# EUROPEAN PATENT APPLICATION

(11) **EP 4 321 928 A1**
(43) Date of publication of application: **14.02.2024**
(21) Application number: 23190205.7
(22) Date of filing: 08.08.2023
(51) Int. Cl.: G03B 21/16, G02F 1/1333

(54) **TEMPERATURE ADJUSTMENT APPARATUS AND CONTROL APPARATUS**

(30) Priority: 08.08.2022 JP 2022126685
(71) Applicant: Seiko Epson Corporation, Tokyo 160-8801 (JP)
(72) Inventor: KADOTANI, Norikazu, Suwa-shi, 392-8502 (JP); NAITO, Yuki, Suwa-shi, 392-8502 (JP); MIYASHITA, Tomoaki, Suwa-shi, 392-8502 (JP); NAKANISHI, Masanobu, Suwa-shi, 392-8502 (JP)
(74) Representative: Lewis Silkin LLP

(57) **Abstract**

A temperature adjustment apparatus adjusting a temperature of a liquid crystal panel module, includes a thermoelectric conversion device in contact with the liquid crystal panel module, and a control unit controlling the thermoelectric conversion device, wherein the liquid crystal panel module includes a thermal diffuser having a contact portion in contact with a liquid crystal panel and an extending portion extending from the contact portion and diffusing received heat, the thermoelectric conversion device has a first surface in contact with the extending portion, and a second surface at an opposite side to the first surface, and the control unit is configured to execute warming processing of supplying heat to the thermal diffuser using the thermoelectric conversion device and warming the liquid crystal panel by the heat diffused in the thermal diffuser, and cooling processing of absorbing the heat of the liquid crystal panel transferred to the thermal diffuser.

## Description

The present application is based on, and claims priority from JP Application Serial Number 2022-126685, filed August 8, 2022, the disclosure of which is hereby incorporated by reference herein in its entirety.

### BACKGROUND

### 1. Technical Field

The present disclosure relates to a temperature adjustment apparatus and a control appa ratus.

### 2. Related Art

In related art, a projector forming an image according to image information and projecting the formed image is known (for example, see JP-A-2015-108697).

The projector disclosed in JP-A-2015-108697 includes a liquid crystal panel modulating incident light and a cooling apparatus cooling the liquid crystal panel. The cooling apparatus includes an optical device holding unit, a liquid pressure feeding unit, a supply tank, a heat exchange unit, a plurality of tubular members, and a cooling fan. Of these elements, the optical device holding unit has a channel in which a cooling liquid circulates and holds the liquid crystal panel. The heat exchange unit is coupled to the optical device holding unit via the plurality of tubular members. In the heat exchange unit, the cooling liquid circulates from the optical device holding unit. The heat exchange unit includes a heat receiving portion, a Peltier element as a thermoelectric conversion element, a heat sink, or the like. The heat receiving portion receives heat of the liquid crystal panel via the optical device holding unit and the cooling liquid, and the Peltier element conducts the heat received by the heat receiving portion to the heat sink. The cooling fan blows cooling air to the heat sink and dissipates the heat of the heat sink.

As described above, in the projector disclosed in JP-A-2015-108697, a heat source as the liquid crystal panel is cooled by a liquid refrigerant. When the temperature of the liquid refrigerant is lower, the cooling effect for the heat source is higher than that of a cooling system of cooling the heat source by circulation of cooling air.

However, the specific heat of the liquid refrigerant is higher, and it takes time to decrease the temperature of the liquid refrigerant to a temperature suitable for cooling of the heat source. Accordingly, in the configuration disclosed in JP-A-2015-108697, when the temperature of the liquid refrigerant is higher than a desired temperature, it is difficult to cool the liquid crystal panel to the desired temperature.

On the other hand, when the temperature of the liquid crystal panel is lower, responsiveness of liquid crystal becomes lower. Accordingly, when the temperature of the liquid crystal panel is lower, it may be possible that image formation by the liquid crystal panel is not appropriately performed until the temperature of the liquid crystal panel becomes higher by entry of light or the like.

Due to these problems, a configuration that can adjust the temperature of the liquid crystal panel is desired.

### SUMMARY

A temperature adjustment apparatus according to a first aspect of the present disclosure is a temperature adjustment apparatus adjusting a temperature of a liquid crystal panel module, including a thermoelectric conversion device in contact with the liquid crystal panel module, and a control unit controlling the thermoelectric conversion device, wherein the liquid crystal panel module includes a liquid crystal panel, and a thermal diffuser having a contact portion in contact with the liquid crystal panel and an extending portion extending from the contact portion and diffusing received heat, the thermoelectric conversion device has a first surface in contact with the extending portion, and a second surface at an opposite side to the first surface, and the control unit is configured to execute warming processing of supplying heat to the thermal diffuser using the thermoelectric conversion device and warming the liquid crystal panel by the heat diffused in the thermal diffuser and transferred to the liquid crystal panel via the contact portion, and cooling processing of absorbing the heat of the liquid crystal panel transferred to the thermal diffuser by the thermoelectric conversion device via the contact portion and diffused in the thermal diffuser.

A control apparatus according to a second aspect of the present disclosure is a control apparatus controlling a temperature of a liquid crystal panel of a light modulation unit including the liquid crystal panel, a thermal diffuser in contact with the liquid crystal panel and diffusing received heat inside, and a thermoelectric conversion device in contact with the thermal diffuser, configured to execute warming processing of supplying heat to the thermal diffuser using the thermoelectric conversion device and warming the liquid crystal panel by the heat diffused in the thermal diffuser and transferred to the liquid crystal panel, and cooling processing of absorbing the heat of the liquid crystal panel transferred from the liquid crystal panel to the thermal diffuser by the thermoelectric conversion device and diffused in the thermal diffuser.

### BRIEF DESCRIPTION OF THE DRAWINGS

FIG. 1 is a schematic diagram showing a configuration of a projector in a first embodiment.
FIG. 2 is a perspective view showing a light modulation unit in the first embodiment.
FIG. 3 is a perspective view showing the light modulation unit in the first embodiment.
FIG. 4 is an exploded perspective view showing the light modulation unit in the first embodiment.
FIG. 5 is an exploded perspective view showing the light modulation unit in the first embodiment.
FIG. 6 is a sectional view showing the light modulation unit in the first embodiment.
FIG. 7 is a block diagram showing a configuration of a part of the light modulation unit and a configuration of a temperature adjustment apparatus in the first embodiment.
FIG. 8 is a side view showing the light modulation unit and a drive unit in the first embodiment.
FIG. 9 is a flowchart showing temperature adjustment processing in the first embodiment.
FIG. 10 is a flowchart showing cooling processing in the first embodiment.
FIG. 11 is a flowchart showing warming processing in the first embodiment.
FIG. 12 is a flowchart showing a modification of the warming processing in the first embodiment.
FIG. 13 is a perspective view showing a light modulation unit of a projector in a second embodiment.
FIG. 14 is an exploded perspective view showing the light modulation unit in the second embodiment.
FIG. 15 is a block diagram showing a configuration of a temperature adjustment apparatus in the second embodiment.
FIG. 16 is a schematic diagram showing another example of a circulation channel of a liquid refrigerant in the second embodiment.
FIG. 17 is a sectional view showing a modification of a thermal diffuser in the first and second embodiments.

### DESCRIPTION OF EMBODIMENTS

### First Embodiment

As below, a first embodiment of the present disclosure will be explained with reference to the drawings.

### Schematic Configuration of Projector

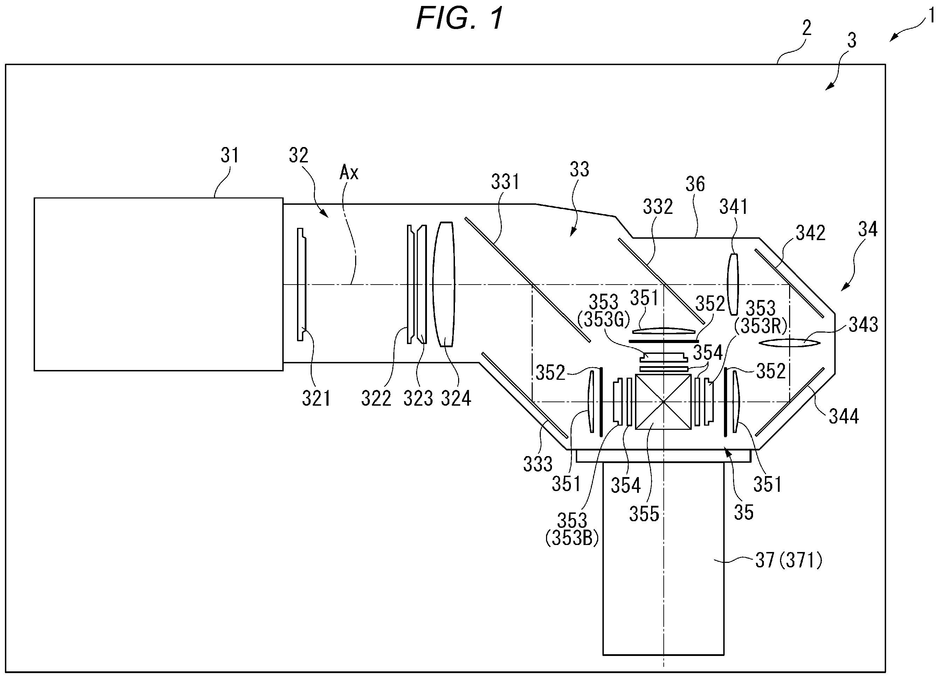

FIG. 1 is a schematic diagram showing a configuration of a projector 1 according to the embodiment.

The projector 1 according to the embodiment is an image display apparatus modulating a light output from a light source 31 provided inside, forming an image light according to image information, and enlarges and projects the formed image light on a projected surface such as a screen. The projector 1 is an example of an electronic apparatus of the present disclosure.

As shown in FIG. 1, the projector 1 includes an exterior housing 2 and an image projection apparatus 3 housed in the exterior housing 2.

### Configuration of Image Projection Apparatus

The image projection apparatus 3 forms an image light according to input image information and projects the formed image light. The image projection apparatus 3 includes the light source 31, a homogenization system 32, a color separation system 33, a relay system 34, an image forming device 35, an optical component housing 36, and a projection optical device 37.

The light source 31 outputs an illumination light to the homogenization system 32. As a configuration of the light source 31, a configuration having e.g., a solid-state light source outputting a blue light as an excitation light and a wavelength conversion element converting at least a part of the blue light output from the solid-state light source into fluorescence containing a green light and a red light may be exemplified. Note that, as another configuration of the light source 31, a configuration having a light source lamp such as a super high-pressure mercury lamp or a configuration having light emitting devices individually outputting a blue light, a green light, and a red light may be exemplified.

The homogenization system 32 homogenizes the light output from the light source 31. The homogenized light illuminates a modulation area of a light modulation unit 353, which will be described later, via the color separation system 33 and the relay system 34. The homogenization system 32 includes two lens arrays 321, 322, a polarization conversion element 323, and a superimposing lens 324.

The color separation system 33 separates the light entering from the homogenization system 32 into respective color lights of red, green, and blue. The color separation system 33 includes two dichroic mirrors 331, 332 and a reflection mirror 333 reflecting the blue light separated by the dichroic mirror 331.

The relay system 34 is provided in an optical path of the red light longer than optical paths of the other color lights and suppresses a loss of the red light. The relay system 34 includes a light incident-side lens 341, a relay lens 343, and reflection mirrors 342, 344. In the embodiment, the red light is guided to the relay system 34. However, for example, a color light having an optical path longer than the other color lights may be a blue light and the blue light may be guided to the relay system 34.

The image forming device 35 modulates the respective entered color lights of red, green, and blue, combines the respective modulated color lights, and forms an image light. The image forming device 35 has three field lenses 351 provided according to the entered color lights, three light incident-side polarizers 352, three light modulation units 353, three light exiting-side polarizers 354, and one light combining system 355.

The light modulation unit 353 modulates the light output from the light source 31 based on an image signal. Specifically, the light modulation unit 353 modulates the color light entering from the light incident-side polarizer 352 according to the image signal and outputs the modulated color light. The three light modulation units 353 include a light modulation unit 353R for red light, a light modulation unit 353G for green light, and a light modulation unit 353B for blue light. The configuration of the light modulation unit 353 will be descried later in detail.

The light combining system 355 combines the three color lights modulated by the light modulation units 353B, 353G, 353R and forms an image light. The image light formed by the light combining system 355 enters the projection optical device 37. In the embodiment, the light combining system 355 includes a cross dichroic prism having a substantially rectangular parallelepiped shape, however, may include a plurality of dichroic mirrors.

The optical component housing 36 houses the above described homogenization system 32, color separation system 33, relay system 34, and image forming device 35 inside. Note that an optical axis Ax in design is set for the image projection apparatus 3, and the optical component housing 36 holds the homogenization system 32, the color separation system 33, the relay system 34, and the image forming device 35 in predetermined positions on the optical axis Ax. The light source 31 and the projection optical device 37 are placed in predetermined positions on the optical axis Ax.

The projection optical device 37 projects the image light entering from the image forming device 35 on a projected surface such as a screen. The projection optical device 37 may be e.g., an assembled lens including a plurality of lenses (not shown) and a lens tube 371 housing the plurality of lenses.

### Configuration of Light Modulation Unit

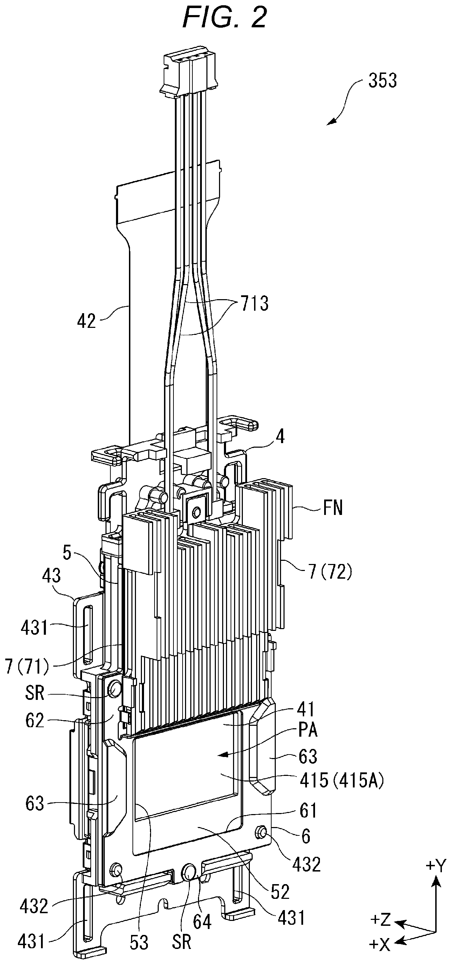

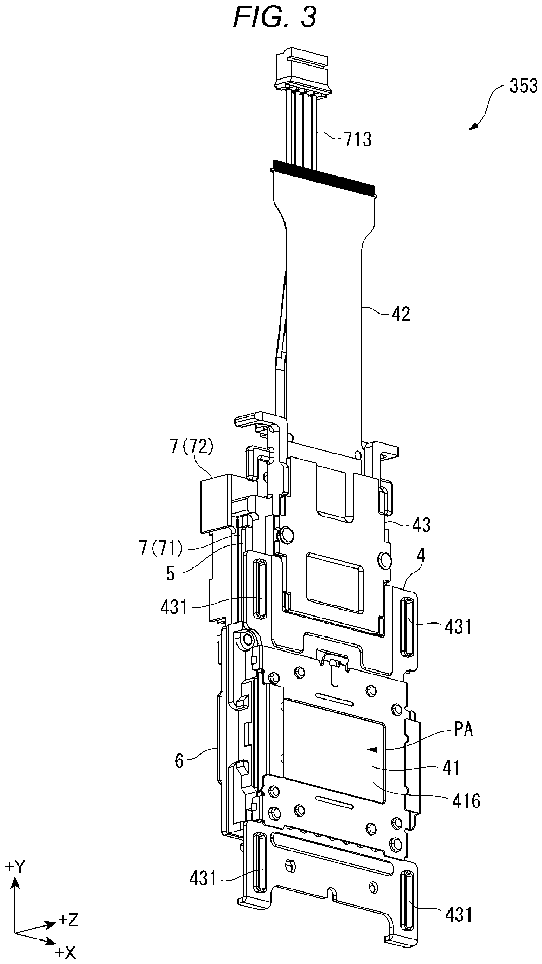

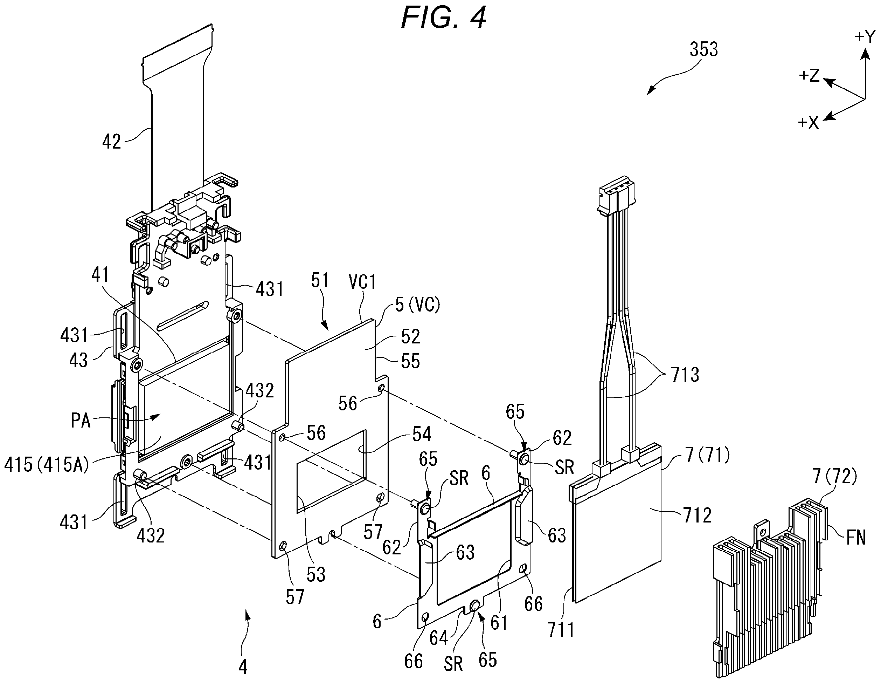

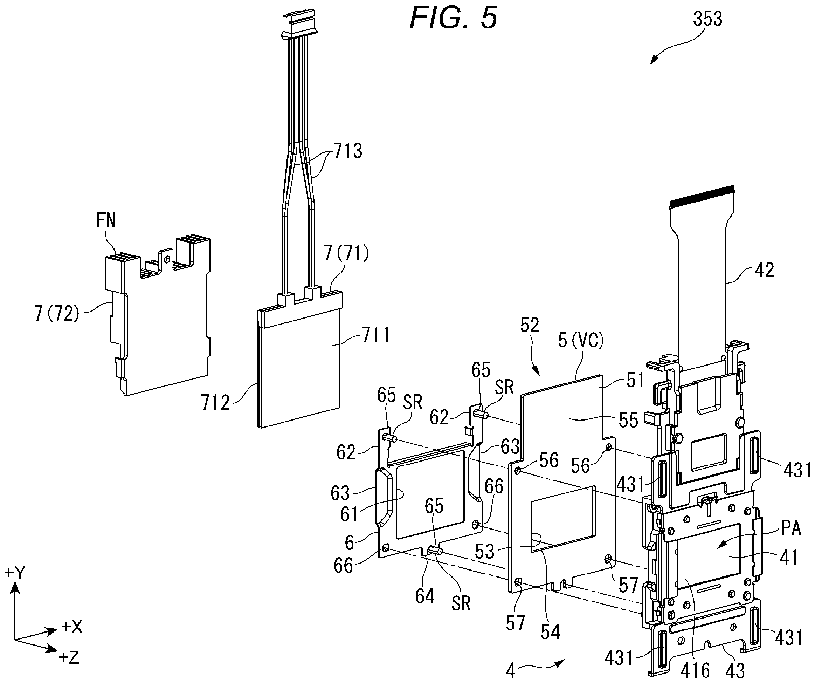

FIG. 2 is a perspective view showing the light modulation unit 353 as seen from a light incident side, FIG. 3 is a perspective view showing the light modulation unit 353 as seen from a light exiting side, FIG. 4 is an exploded perspective view showing the light modulation unit 353 as seen from the light incident side, and FIG. 5 is an exploded perspective view showing the light modulation unit 353 as seen from the light exiting side.

As shown in FIGS. 2 to 5, the light modulation unit 353 includes a liquid crystal panel module 4, a holding member 6, a thermoelectric conversion device 71, and a cooler 72. The thermoelectric conversion device 71 and the cooler 72 form the light modulation unit 353 and form a temperature adjustment apparatus 7, which will be described later.

In the following description, three directions orthogonal to one another are a +X direction, a +Y direction, and a +Z direction. In the embodiment, the +Z direction is a traveling direction of light entering the light modulation unit 353. The leftward direction when the light modulation unit 353 is seen along the +Z direction so that the +Y direction may coincide with the upward direction is the +X direction. Though not illustrated, the opposite direction to the +X direction is a -X direction, the opposite direction to the +Y direction is a -Y direction, and the opposite direction to the +Z direction is a -Z direction. That is, the +Z direction with respect to the light modulation unit 353 is the light exiting side of the light modulation unit 353 and the - Z direction with respect to the light modulation unit 353 is the light incident side of the light modulation unit 353.

Further, an axis along the +X direction or the -X direction is an X-axis, an axis along the +Y direction or the -Y direction is a Y-axis, and an axis along the +Z direction or the -Z direction is a Z-axis.

### Configuration of Liquid Crystal Panel Module

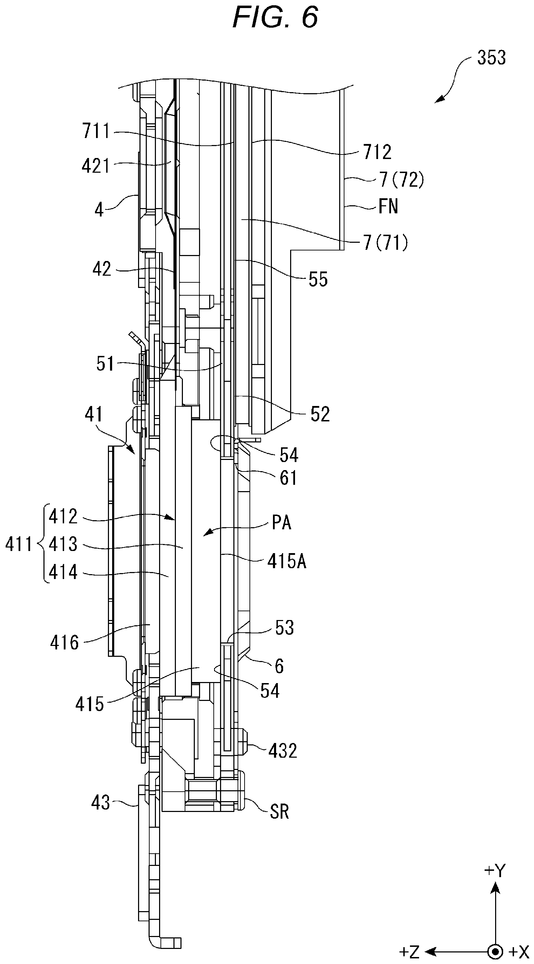

FIG. 6 shows a section of the light modulation unit 353 along the YZ-plane.

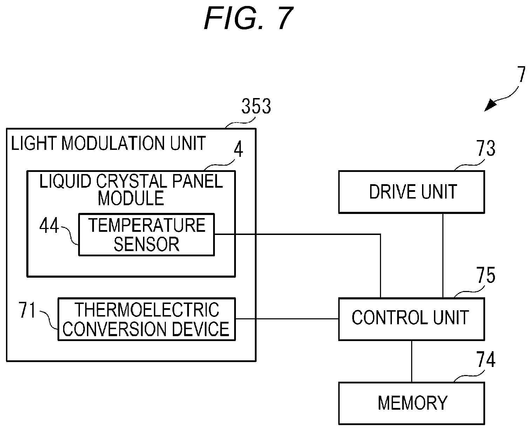

The liquid crystal panel module 4 modulates the entering light, forms an image according to an image signal, and outputs the formed image. As shown in FIG. 6, the liquid crystal panel module 4 includes a liquid crystal panel 41, an FPC (Flexible printed circuits) 42, a holding frame 43, and a thermal diffuser 5. In addition, as shown in FIG. 7, which will be described later, the liquid crystal panel module 4 includes a temperature sensor 44.

The temperature sensor 44 is provided on e.g., the holding frame 43 and detects the temperature of the liquid crystal panel 41. The temperature sensor 44 outputs a detection result to a control unit 75 of the temperature adjustment apparatus 7, which will be described later.

### Configuration of Liquid Crystal Panel

The liquid crystal panel 41 modulates the entering light and outputs the modulated light along the traveling direction of the entering light. The liquid crystal panel 41 is a heat source in the light modulation unit 353. The liquid crystal panel 41 includes an optical action unit 411 and a light incident-side dustproof substrate 415 and a light exiting-side dustproof substrate 416 sandwiching the optical action unit 411 on the Z-axis.

### Configuration of Optical Action Unit

The optical action unit 411 has a liquid crystal layer 412 and a counter substrate 413 and a pixel substrate 414 sandwiching the liquid crystal layer 412 on the Z-axis.

The liquid crystal layer 412 is formed by liquid crystal molecules sealed between the counter substrate 413 and the pixel substrate 414.

The counter substrate 413 is placed at the light incident side with respect to the liquid crystal layer 412. On the counter substrate 413, a counter electrode is provided on the surface facing the liquid crystal layer 412.

The pixel substrate 414 is placed at the light exiting side with respect to the liquid crystal layer 412. On the pixel substrate 414, a plurality of pixel electrodes are provided on the surface facing the liquid crystal layer 412. Note that, as seen from the -Z direction as the light incident side, an area where the plurality of pixel electrodes are placed in the optical action unit 411 is a pixel area PA, and one pixel is formed by an area where each pixel electrode is placed in the pixel area PA.

The counter substrate 413 and the pixel substrate 414 are coupled to the FPC 42 and change the alignment condition of the liquid crystal molecules forming the liquid crystal layer 412 according to the image signal supplied from the FPC 42. Thereby, the optical action unit 411 modulates the entering light.

### Configuration of Light Incident-side Dustproof Substrate

The light incident-side dustproof substrate 415 is a light-transmissive substrate provided in a portion corresponding to the pixel area PA on the light incident surface of the counter substrate 413. When the liquid crystal panel module 4 is seen from the -Z direction, the light incident-side dustproof substrate 415 is heat-transferably provided to the light incident surface of the counter substrate 413 to cover the pixel area PA. The light incident-side dustproof substrate 415 suppresses attachment of dust or the like to the light incident surface of the counter substrate 413 and entry of a shadow of the dust or the like into the image light.

Note that the thermal diffuser 5 is coupled to the light incident-side dustproof substrate 415. Specifically, a contact portion 54 of the thermal diffuser 5 heat-transferably contacts a light incident surface 415A in the light incident-side dustproof substrate 415. The light incident surface 415A is a heat transfer surface transferring heat generated in the optical action unit 411 of the liquid crystal panel 41 to the thermal diffuser 5. That is, the liquid crystal panel module 4 has the liquid crystal panel 41 outputting the entering light and the light incident surface 415A as the heat transfer surface transferring the heat of the liquid crystal panel 41.

### Configuration of Light Exiting-side Dustproof Substrate

The light exiting-side dustproof substrate 416 is a light-transmissive substrate provided in a portion corresponding to the pixel area PA on the light exiting surface of the pixel substrate 414. When the liquid crystal panel module 4 is seen from the +Z direction, the light exiting-side dustproof substrate 416 is heat-transferably provided to the light exiting surface of the pixel substrate 414 to cover the pixel area PA. The light exiting-side dustproof substrate 416 suppresses direct attachment of dust or the like to the light exiting surface of the pixel substrate 414 and entry of a shadow of the dust or the like into the image light.

### Configuration of FPC

As shown in FIG. 6, the FPC 42 extends from the counter substrate 413 and the pixel substrate 414 in the + Y direction and is coupled to the above described control apparatus. The FPC 42 has a driver circuit 421 driving the optical action unit 411, and the driver circuit 421 applies a drive signal according to the input image signal to the pixel substrate 414.

### Configuration of Holding Frame

The holding frame 43 holds the liquid crystal panel 41 and the FPC 42 and supports the thermal diffuser 5, the holding member 6, the thermoelectric conversion device 71, and the cooler 72. As shown in FIGS. 3 and 5, the holding frame 43 is formed in a rectangular shape elongated in the +Y direction as seen from the light exiting side. Though not illustrated, the holding frame 43 has an opening portion through which a light entering the liquid crystal panel 41 and a light outputting from the liquid crystal panel 41 pass. The holding frame 43 has four through holes 431 penetrating the holding frame 43 along the Z-axis. Though not illustrated, in each of the four through holes 431, an arm portion of a supporting member provided in the light combining system 355 is inserted. The supporting member is provided in each of three light incident surfaces into which the color lights modulated by the light modulation units 353 in the light combining system 355, the arm portions are inserted into the through holes 431, and thereby, the light combining system 355 and the three light modulation units 353 are integrated.

### Configuration of Thermal Diffuser

The thermal diffuser 5 receives heat of the liquid crystal panel 41 from the light incident surface 415A of the light incident-side dustproof substrate 415 and diffuses the received heat in the thermal diffuser 5. As shown in FIGS. 4 and 5, the thermal diffuser 5 is formed substantially in a rectangular shape elongated along the Y-axis as seen from the +Z direction and placed at the light incident side with respect to the liquid crystal panel 41, the FPC 42, and the holding frame 43. Specifically, the thermal diffuser 5 is placed between the liquid crystal panel 41 and the thermoelectric conversion device 71. The thermal diffuser 5 includes a first surface 51, a second surface 52, an opening portion 53, the contact portion 54, an extending portion 55, two hole portions 56, and two hole portions 57.

The first surface 51 is a surface facing the liquid crystal panel 41 in the thermal diffuser 5. In other words, the first surface 51 is a surface at a light exiting side in the thermal diffuser 5.

The second surface 52 is a surface at the opposite side to the first surface 51 in the thermal diffuser 5. The holding member 6 and the thermoelectric conversion device 71, which will be described later, contact the second surface 52.

The opening portion 53 passes the light entering the liquid crystal panel 41 in the +Z direction when the thermal diffuser 5 is attached to the holding frame 43. That is, the opening portion 53 is a through hole penetrating the thermal diffuser 5 in the +Z direction. The opening portion 53 is formed substantially in a rectangular shape corresponding to the pixel area PA as seen from the light incident side.

The contact portion 54 is provided on the peripheral edge of the opening portion 53 in the first surface 51. The contact portion 54 contacts the light incident surface 415A as the heat transfer surface and receives the heat of the liquid crystal panel 41 from the light incident surface 415A.

The extending portion 55 is a portion extending in a direction crossing the incident direction of the light from the contact portion 54 to the liquid crystal panel 41 in the thermal diffuser 5. Specifically, the extending portion 55 is a portion extending from the contact portion 54 in a direction away from the pixel area PA outputting the image light in the liquid crystal panel module 4. More specifically, the extending portion 55 is a portion extending from the contact portion 54 in the +Y direction crossing the Z-axis. In the thermal diffuser 5, the heat of the liquid crystal panel 41 received in the contact portion 54 is diffused in the extending portion 55. The heat diffused in the extending portion 55 is absorbed by the thermoelectric conversion device 71 in contact with the second surface 52.

The two hole portions 56 are provided in the +Y direction with respect to the opening portion 53. Screws SR to be fastened to the holding frame 43 are inserted through the respective two hole portions 56.

The two hole portions 57 are provided in the -Y direction with respect to the opening portion 53. As shown in FIG. 4, projections 432 provided on the holding frame 43 are inserted through the respective two hole portions 57. That is, the projections 432 are positioning projections and the two hole portions 57 are positioning holes.

In the embodiment, the thermal diffuser 5 is a vapor chamber VC having a sealed housing VC1 in which a working fluid that can change in a vapor phase and a liquid phase is sealed.

The first surface 51 is a surface facing the liquid crystal panel 41 in the sealed housing VC1 and the second surface 52 is a surface at the opposite side to the first surface 51 in the sealed housing VC1. The contact portion 54 and the extending portion 55 are provided in the sealed housing VC1 and the contact portion 54 is a heat receiving portion receiving the heat of the liquid crystal panel 41 in the sealed housing VC1.

A partial working fluid of the liquid-phase working fluid sealed within the sealed housing VC1 is gasified by the heat of the liquid crystal panel 41 received in the contact portion 54 and changes to a working fluid in a vapor phase and is diffused within the sealed housing VC1.

A part of the vapor-phase working fluid transfers the heat to a portion at a lower temperature in the sealed housing VC1. Thereby, the vapor-phase working fluid is condensed and changes to a liquid-phase working fluid. The working fluid changed into the liquid phase is moved along the inner surface of the sealed housing VC1 to the heat receiving portion again.

The portion of the sealed housing VC1 to which the heat is transferred is a heat dissipating portion and the transferred heat is dissipated in the heat dissipating portion. In the second surface 52, the thermoelectric conversion device 71 is provided in the extending portion 55, and the portion in which the thermoelectric conversion device 71 is provided is the heat dissipating portion in the sealed housing VC1.

### Configuration of Holding Member

As shown in FIGS. 4 and 5, the holding member 6 is formed substantially in a rectangular shape. The holding member 6 is fixed to the holding frame 43 by the screws SR and holds the light incident-side polarizer 352 shown in FIG. 1 at the light incident side with respect to the liquid crystal panel 41. The holding member 6 has an opening portion 61, two arm portions 62, two fixing portions 63, a projecting portion 64, three hole portions 65, and two hole portions 66.

The opening portion 61 is a rectangular opening portion and provided in a position corresponding to the pixel area PA when the holding member 6 is fixed to the holding frame 43. The light output from the light incident-side polarizer 352 in the +Z direction passes through the opening portion 61, further passes through the opening portion 53 of the thermal diffuser 5, and enters the liquid crystal panel 41.

Of the two arm portions 62, one arm portion 62 projects from an end part in the +X direction in the holding member 6 in the +Y direction, and the other arm portion 62 projects from an end part in the -X direction in the holding member 6 in the +Y direction.

Of the two fixing portions 63, one fixing portion 63 is provided in the +X direction with respect to the opening portion 61 and the other fixing portion 63 is provided in the -X direction with respect to the opening portion 61. The respective fixing portions 63 project in the -Z direction and the light incident-side polarizer 352 is fixed by an adhesive agent or the like at the light incident side.

The projecting portion 64 projects from the center along the X-axis in the holding member 6 in the -Y direction.

Of the three hole portions 65, the two hole portions 65 are respectively provided in the two arm portions 62 and the other one hole portion 65 is provided in the projecting portion 64. The screws SR to be fastened to the holding frame 43 are inserted through the respective hole portions 65 along the +Z direction.

The two hole portions 66 are provided in corner parts in the -Y direction with respect to the opening portion 61. The projections 432 as the positioning projections provided on the holding frame 43 are inserted into the respective two hole portions 66. That is, the two hole portions 66 are positioning holes.

As described above, the holding member 6 is fixed to the holding frame 43 with the thermal diffuser 5 and holds the light incident-side polarizer 352.

### Configuration of Temperature Adjustment Apparatus

The projector 1 includes the temperature adjustment apparatus 7 adjusting the temperature of the liquid crystal panel 41 of each light modulation unit 353 in addition to the above described configuration. As shown in FIGS. 2 to 6, the temperature adjustment apparatus 7 includes the thermoelectric conversion device 71 and the cooler 72. The cooler 72 is provided in the thermoelectric conversion device 71 and the thermoelectric conversion device 71 is provided in the liquid crystal panel module 4.

### Configuration of Thermoelectric Conversion Device

The thermoelectric conversion device 71 contacts the liquid crystal panel module 4. Specifically, the thermoelectric conversion device 71 is coupled to the thermal diffuser 5 of the liquid crystal panel module 4, and absorbs heat from the thermal diffuser 5 and dissipates the heat. As shown in FIGS. 4 and 5, the thermoelectric conversion device 71 has a first surface 711, a second surface 712, and lead wires 713.

The first surface 711 is a surface facing the thermal diffuser 5 in the thermoelectric conversion device 71. Specifically, the first surface 711 is a surface in contact with the extending portion 55 in the thermoelectric conversion device 71. In other words, the first surface 711 is a surface facing in the +Z direction in the thermoelectric conversion device 71.

The second surface 712 is a surface at the opposite side to the first surface 711 in the thermoelectric conversion device 71. In other words, the second surface 712 is a surface facing in the -Z direction in the thermoelectric conversion device 71. The cooler 72 contacts the second surface 712.

The lead wires 713 extend from end parts in the +Y direction in the thermoelectric conversion device 71 in the +Y direction. The lead wires 713 are coupled to the control unit 75 of the temperature adjustment apparatus 7. That is, the operation of the thermoelectric conversion device 71 is controlled by the control unit 75.

The thermoelectric conversion device 71 actively absorbs the heat transferred from the extending portion 55 in the first surface 711 by electric power supplied from the lead wires 713 and dissipates the absorbed heat from the second surface 712 to the cooler 72.

In the embodiment, the thermoelectric conversion device 71 is a Peltier element. Accordingly, the heat can be supplied from the first surface 711 to the extending portion 55 by inversion of the polarity of the thermoelectric conversion device 71. That is, the thermoelectric conversion device 71 may warm the liquid crystal panel 41 via the thermal diffuser 5. Concurrently, in the thermal diffuser 5, the liquid-phase working fluid near the extending portion 55 changes to the vapor-phase working fluid by the heat supplied from the thermoelectric conversion device 71 and the vapor-phase working fluid is diffused within the sealed housing VC1. Then, a partial working fluid of the vapor-phase working fluid transfers the heat to the contact portion 54 and the heat is supplied from the contact portion 54 to the liquid crystal panel 41. Note that, when heat is supplied from the first surface 711 to the thermal diffuser 5, the second surface 712 serves as a heat absorbing surface and absorbs heat from the cooler 72. The cooler 72 is coupled to the thermoelectric conversion device 71, but not directly coupled to the liquid crystal panel module 4. Further, the thermoelectric conversion device 71 serves as a heat insulating member, and thereby, when the thermoelectric conversion device 71 warms the liquid crystal panel 41, the cooling effect by the thermoelectric conversion device 71 does not act on the liquid crystal panel 41.

### Configuration of Cooler

The cooler 72 is coupled to the second surface 712 of the thermoelectric conversion device 71 and dissipates heat transferred from the thermoelectric conversion device 71. In the embodiment, as shown in FIGS. 2 and 4, the cooler 72 is a heat sink having a plurality of fins FN. The cooler 72 transfers the heat of the liquid crystal panel 41 transferred from the thermoelectric conversion device 71 to a cooling gas circulating by a drive unit 73 of the temperature adjustment apparatus 7 and dissipates the heat of the liquid crystal panel 41.

FIG. 7 is a block diagram showing a configuration of a part of the light modulation unit 353 and a configuration of the temperature adjustment apparatus 7.

As shown in FIG. 7, the temperature adjustment apparatus 7 includes the drive unit 73, a memory 74, and the control unit 75 in addition to the thermoelectric conversion device 71 and the cooler 72. That is, the thermoelectric conversion device 71 and the cooler 72 form the light modulation unit 353 and form the temperature adjustment apparatus 7, and adjust the temperature of the liquid crystal panel 41 under control of the control unit 75.

### Configuration of Drive Unit

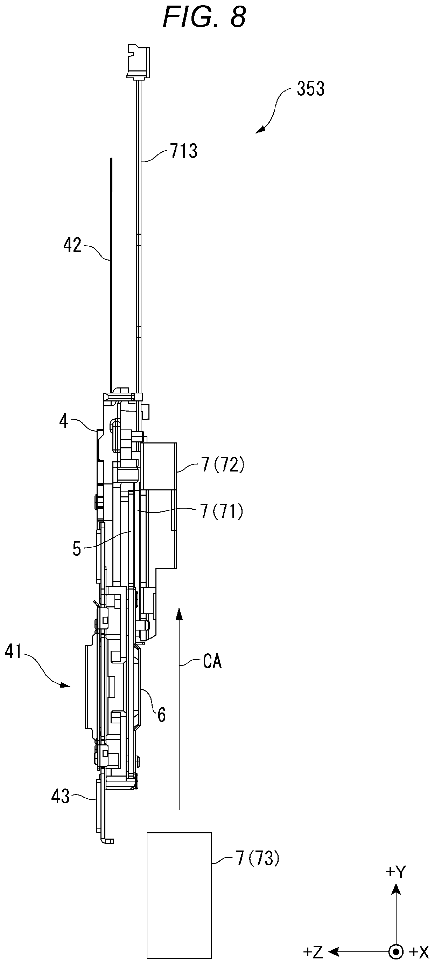

FIG. 8 is a side view showing the light modulation unit 353 and the drive unit 73 as seen from the +X direction.

The drive unit 73 is provided with respect to each light modulation unit 353 and cools the cooler 72. In the embodiment, as shown in FIG. 8, the drive unit 73 includes a cooling fan circulating a cooling gas CA in the cooler 72. The operation of the drive unit 73 is controlled by the control unit 75.

### Configuration of Memory

The memory 74 shown in FIG. 7 stores a temperature adjustment program and data for execution of temperature adjustment processing for the liquid crystal panel 41 executed by the control unit 75. The data stored by the memory 74 includes thresholds used for the temperature adjustment processing. The thresholds stored by the memory 74 are e.g., an upper limit value and a lower limit value of a suitable temperature range of the liquid crystal panel 41. In the embodiment, as the lower limit value of the suitable temperature range, 49 °C is stored in the memory 74 and, as the upper limit value of the suitable temperature range, 60 °C is stored in the memory 74. Further, the memory 74 stores error information representing occurrence of errors. The error information is e.g., an error flag.

### Configuration of Control Unit

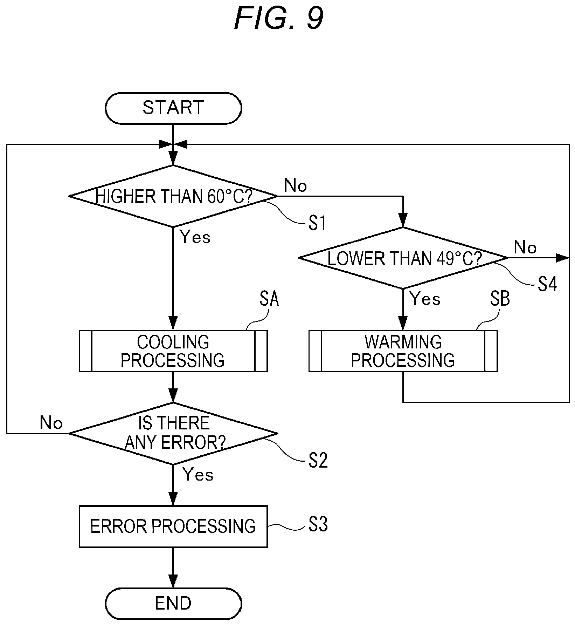

FIG. 9 is a flowchart showing the temperature adjustment processing executed by the control unit 75.

The control unit 75 is a controller controlling the temperature of the liquid crystal panel module 4. The control unit 75 controls the operation of the thermoelectric conversion device 71 and the drive unit 73 to adjust the temperature of the liquid crystal panel 41. Specifically, the control unit 75 controls the operation of the thermoelectric conversion device 71 and the drive unit 73 based on the temperature of the liquid crystal panel 41 detected by the temperature sensor 44.

More specifically, the control unit 75 executes the temperature adjustment processing shown in FIG. 9 on the respective light modulation units 353 with reference to the temperature adjustment program stored in the memory 74.

### Temperature Adjustment Processing

In the temperature adjustment processing, as shown in FIG. 9, the control unit 75 determines whether the temperature of the liquid crystal panel 41 detected by the temperature sensor 44 is higher than 60 °C (step S1).

In the determination processing at step S1, when a determination that the temperature of the liquid crystal panel 41 is higher than 60 °C is made (step S1: Yes), the control unit 75 executes cooling processing SA.

### Cooling Processing

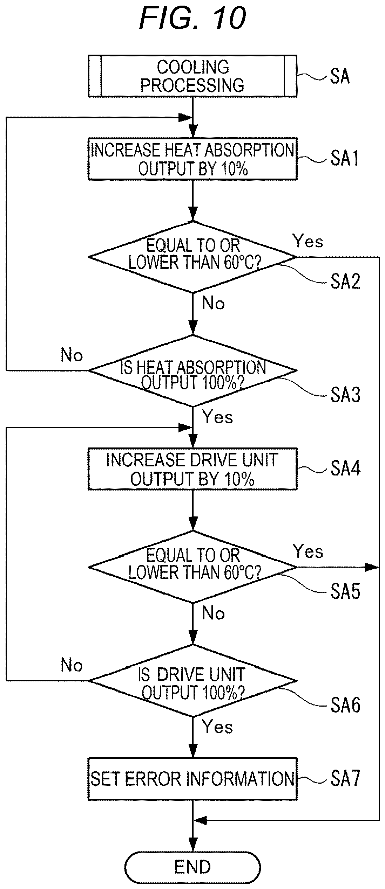

FIG. 10 is a flowchart showing the cooling processing SA.

The cooling processing SA is processing of absorbing heat of the liquid crystal panel 41 transferred to the thermal diffuser 5 via the contact portion 54 by the thermoelectric conversion device 71 and diffused in the thermal diffuser 5. Further, the cooling processing SA is processing of promoting heat dissipation of the heat of the liquid crystal panel 41 by increasing the output of the drive unit 73 and cooling the cooler 72 to which the heat of the liquid crystal panel 41 is transferred. That is, the cooling processing SA includes cooling control of the liquid crystal panel 41 by the thermoelectric conversion device 71 and output increase control of the drive unit 73.

Specifically, in the cooling processing SA, as shown in FIG. 10, the control unit 75 increases heat absorption output of the thermoelectric conversion device 71 as the Peltier element by 10% (step SA1).

Then, the control unit 75 determines whether the temperature of the liquid crystal panel 41 is equal to or lower than 60 °C (step SA2).

In the determination processing at step SA2, when a determination that the temperature of the liquid crystal panel 41 is equal to or lower than 60 °C is made (step SA2: Yes), the control unit 75 ends the cooling processing SA.

In the determination processing at step SA2, when a determination that the temperature of the liquid crystal panel 41 is not equal to or lower than 60 °C is made (step SA2: No), the control unit 75 determines whether the present heat absorption output of the thermoelectric conversion device 71 reaches 100% (step SA3).

In the determination processing at step SA3, when a determination that the heat absorption output of the thermoelectric conversion device 71 does not reach 100% is made (step SA3: No), the control unit 75 moves the processing to step SA1 and executes step SA1 again. Thereby, the heat absorption output of the thermoelectric conversion device 71 is further increased by 10%. As described above, steps SA1 to SA3 are processing for cooling control of the liquid crystal panel 41 by the thermoelectric conversion device 71, and the control unit 75 executes steps SA1 to SA3 and increases the heat absorption output to the liquid crystal panel 41 by the thermoelectric conversion device 71 in a stepwise manner.

In the determination processing at step SA3, when a determination that the heat absorption output of the thermoelectric conversion device 71 reaches 100% is made (step SA3: Yes), the control unit 75 increases the output of the drive unit 73 as the cooling fan by 10% (step SA4).

After step SA4, the control unit 75 determines whether the temperature of the liquid crystal panel 41 is equal to or lower than 60 °C (step SA5).

In the determination processing at step SA5, when a determination that the temperature of the liquid crystal panel 41 is equal to or lower than 60 °C is made (step SA5: Yes), the control unit 75 ends the cooling processing SA.

In the determination processing at step SA5, when a determination that the temperature of the liquid crystal panel 41 is not equal to or lower than 60 °C is made (step SA5: No), the control unit 75 determines whether the present output of the drive unit 73 reaches 100% as an output upper limit value (step SA6).

In the determination processing at step SA6, when a determination that the output of the drive unit 73 does not reach 100% is made (step SA6: No), the control unit 75 moves the processing to step SA4 and executes step SA4 again. Thereby, the output of the drive unit 73 is further increased by 10%. As described above, steps SA4 to SA6 are processing for output increase control of the drive unit 73, and the control unit 75 executes steps SA4 to SA6 and increases the output of the drive unit 73 in a stepwise manner.

In the determination processing at step SA6, when a determination that the output of the drive unit 73 reaches 100% is made (step SA6: Yes), the control unit 75 sets the error information (step SA7). Specifically, at step SA7, the control unit 75 stores the error information representing that the temperature of the liquid crystal panel 41 is out of the suitable temperature range in the memory 74.

After step SA7, the control unit 75 ends the cooling processing SA.

Returning to FIG. 9, when the cooling processing SA is ended, the control unit 75 determines whether an error occurs (step S2). Specifically, the control unit 75 determines whether the error information is stored in the memory 74.

In the determination processing at step S2, when a determination that an error occurs is made (step S2: Yes), the control unit 75 stops the system (step S3). For example, at step S3, the control unit 75 informs a user of the occurrence of an error by lighting of an indicator indicating the occurrence of the error or the like, and turns off the light source 31 and powers off the projector 1. Thereby, the temperature adjustment processing is finished.

In the determination processing at step S2, when a determination that an error does not occur is made (step S2: No), the control unit 75 moves the processing to step S1 and executes the determination processing at step S1 again.

In the determination processing at step S1, when a determination that the temperature of the liquid crystal panel 41 is not higher than 60 °C is made (step S1: No), the control unit 75 determines whether the temperature of the liquid crystal panel 41 is lower than 49 °C (step S4).

In the determination processing at step S4, when a determination that the temperature of the liquid crystal panel 41 is not lower than 49 °C is made (step S4: No), the control unit 75 moves the processing to step S1. In this state, the temperature of the liquid crystal panel 41 takes a value within the suitable temperature range.

In the determination processing at step S4, when a determination that the temperature of the liquid crystal panel 41 is lower than 49 °C is made (step S4: Yes), the control unit 75 executes warming processing SB.

### Warming Processing

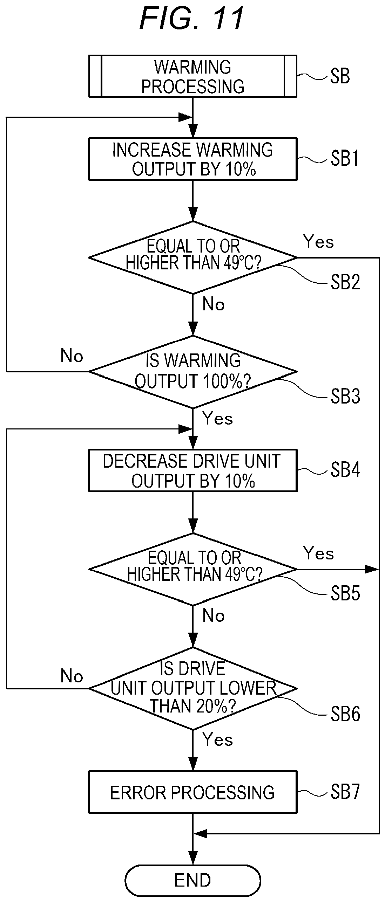

FIG. 11 is a flowchart showing the warming processing SB.

The warming processing SB is processing of supplying heat to the thermal diffuser 5 by the thermoelectric conversion device 71 and warming the liquid crystal panel 41 by the heat diffused in the thermal diffuser 5 and transferred to the liquid crystal panel 41 via the contact portion 54. Further, the warming processing SB is processing of decreasing the output of the drive unit 73 to suppress heat dissipation of the heat of the liquid crystal panel 41 and warming the liquid crystal panel 41. That is, the warming processing SB includes warming control of the liquid crystal panel 41 by the thermoelectric conversion device 71 and output decrease control by the drive unit 73.

Specifically, in the warming processing SB, as shown in FIG. 11, the control unit 75 increases warming output of the thermoelectric conversion device 71 as the Peltier element by 10% (step SB1). Concurrently, the control unit 75 sets polarity of the Peltier element to be opposite in the cooling processing SA and the warming processing SB.

Then, the control unit 75 determines whether the temperature of the liquid crystal panel 41 is equal to or higher than 49 °C (step SB2).

In the determination processing at step SB2, when a determination that the temperature of the liquid crystal panel 41 is equal to or higher than 49 °C is made (step SB2: Yes), the control unit 75 ends the warming processing SB.

In the determination processing at step SB2, when a determination that the temperature of the liquid crystal panel 41 is not equal to or higher than 49 °C is made (step SB2: No), the control unit 75 determines whether the present warming output of the thermoelectric conversion device 71 reaches 100% (step SB3).

In the determination processing at step SB3, when a determination that the warming output of the thermoelectric conversion device 71 does not reach 100% is made (step SB3: No), the control unit 75 moves the processing to step SB1 and executes step SB1 again. Thereby, the warming output of the thermoelectric conversion device 71 is further increased by 10%. As described above, steps SB1 to SB3 are processing for warming control of the liquid crystal panel 41 by the thermoelectric conversion device 71, and the control unit 75 executes steps SB1 to SB3 and increases the warming output to the liquid crystal panel 41 by the thermoelectric conversion device 71 in a stepwise manner.

In the determination processing at step SB3, when a determination that the warming output of the thermoelectric conversion device 71 reaches 100% is made (step SB3: Yes), the control unit 75 decreases the output of the drive unit 73 as the cooling fan by 10% (step SB4). That is, in the warming processing SB, the control unit 75 executes the warming control of the liquid crystal panel 41 by the thermoelectric conversion device 71 in preference to the output decrease control of the drive unit 73.

After step SB4, the control unit 75 determines whether the temperature of the liquid crystal panel 41 is equal to or higher than 49 °C (step SB5).

In the determination processing at step SB5, when a determination that the temperature of the liquid crystal panel 41 is equal to or higher than 49 °C is made (step SB5: Yes), the control unit 75 ends the warming processing SB.

In the determination processing at step SB5, when a determination that the temperature of the liquid crystal panel 41 is not equal to or higher than 49 °C is made (step SB5: No), the control unit 75 determines whether the present output of the drive unit 73 reaches 20% as an output lower limit value (step SB6). Specifically, at step SB6, the control unit 75 determines whether the present output of the drive unit 73 is lower than 20%.

In the determination processing at step SB6, when a determination that the output of the drive unit 73 is not lower than 20% is made (step SB6: No), the control unit 75 moves the processing to step SB4 and executes step SB4 again. Thereby, the output of the drive unit 73 is further decreased by 10%. As described above, steps SB4 to SB6 are processing for output decrease control of the drive unit 73, and the control unit 75 executes steps SB4 to SB6 and decreases the output of the drive unit 73 in a stepwise manner.

In the determination processing at step SB6, when a determination that the output of the drive unit 73 is lower than 20% is made (step SB6: Yes), the control unit 75 executes error processing (step SB7). For example, at step SB7, the control unit 75 restricts resolution of the image formed by the liquid crystal panel 41. Specifically, the control unit 75 reduces the frame rate of the image formed by the liquid crystal panel 41 and restricts image formation with the maximum resolution that can be formed by the liquid crystal panel 41.

After the step SB7, the control unit 75 ends the warming processing SB.

Returning to FIG. 9, when the warming processing SB is ended, the control unit 75 returns the processing to step S1 and monitors the temperature of the liquid crystal panel 41.

As described above, the temperature adjustment processing of the liquid crystal panel 41 by the control unit 75 is continuously executed while the power of the projector 1 is on.

Note that it is preferable that the drive unit 73 as the cooling fan circulating the cooling gas CA in the cooler 72 is driven at the same time as the power on of the projector 1. It is preferable that the drive unit 73 does not only circulate the cooling gas CA in the cooler 72 but also circulates the cooling gas CA in at least one of the polarization conversion element 323 of the homogenization system 32 and the light source 31 using a duct or the like.

### Effects of First Embodiment

The projector 1 according to the above described embodiment exerts the following effects.

The temperature adjustment apparatus 7 adjusts the temperature of the liquid crystal panel module 4. The temperature adjustment apparatus 7 includes the thermoelectric conversion device 71 in contact with the liquid crystal panel module 4 and the control unit 75 controlling the thermoelectric conversion device 71. The liquid crystal panel module 4 includes the liquid crystal panel 41 and the thermal diffuser 5. The thermal diffuser 5 has the contact portion 54 in contact with the liquid crystal panel 41 and the extending portion 55 extending from the contact portion 54. The thermal diffuser 5 diffuses the received heat. The thermoelectric conversion device 71 has the first surface 711 in contact with the extending portion 55 and the second surface 712 at the opposite side to the first surface 711.

The control unit 75 can execute the cooling processing SA and the warming processing SB. The cooling processing SA is the processing of absorbing the heat of the liquid crystal panel 41 transferred to the thermal diffuser 5 via the contact portion 54 by the thermoelectric conversion device 71 and diffused in the thermal diffuser 5. The warming processing SB is the processing of supplying heat to the thermal diffuser 5 by the thermoelectric conversion device 71 and warming the liquid crystal panel 41 by the heat diffused in the thermal diffuser 5 and transferred to the liquid crystal panel 41 via the contact portion 54.

According to the configuration, the temperature of the liquid crystal panel 41 may be increased via the thermal diffuser 5 by the thermoelectric conversion device 71 by the control unit 75 executing the warming processing SB. Thereby, responsiveness reduction of the liquid crystal of the liquid crystal panel 41 and image degradation may be suppressed.

Further, the heat transferred from the liquid crystal panel 41 to the thermal diffuser 5 may be actively absorbed by the thermoelectric conversion device 71 by the control unit 75 executing the cooling processing SA. Thereby, the higher temperature of the liquid crystal panel 41 may be suppressed and the shorter life of the liquid crystal panel 41 may be suppressed.

Therefore, the temperature of the liquid crystal panel 41 may be adjusted by the temperature adjustment apparatus 7.

The temperature adjustment apparatus 7 includes the memory 74 storing the upper limit value and the lower limit value of the suitable temperature range of the liquid crystal panel 41 as thresholds. The liquid crystal panel module 4 includes the temperature sensor 44 detecting the temperature. The control unit 75 executes one of the cooling processing SA and the warming processing SB based on the comparison result of the detection value by the temperature sensor 44 and the upper limit value and the lower limit value.

According to the configuration, the detection value by the temperature sensor 44 and the upper limit value and the lower limit value stored in the memory 74 are compared, and thereby, the control unit 75 may appropriately determine which to execute the cooling processing SA and the warming processing SB. Therefore, the temperature adjustment of the liquid crystal panel 41 may be appropriately performed.

The temperature adjustment apparatus 7 includes the cooler 72 in contact with the second surface 712 and the drive unit 73 cooling the cooler 72. Specifically, the temperature adjustment apparatus 7 includes the drive unit 73 as the cooling fan cooling the cooler 72 in contact with the second surface 712 of the thermoelectric conversion device 71.

According to the configuration, compared to a case without the cooler 72 and the drive unit 73, the cooling efficiency of the liquid crystal panel 41 may be increased.

The warming processing SB includes the warming control of the liquid crystal panel 41 by the thermoelectric conversion device 71 and the output decrease control of the drive unit 73.

According to the configuration, the control unit 75 controls the thermoelectric conversion device 71 and the drive unit 73, and thereby, the temperature adjustment of the liquid crystal panel 41 in the warming processing SB may be finely performed.

In the warming processing SB, the control unit 75 executes the warming control of the liquid crystal panel 41 by the thermoelectric conversion device 71 in preference to the output decrease control of the drive unit 73.

Here, the warming of the liquid crystal panel 41 by the thermoelectric conversion device 71 may increase the temperature of the liquid crystal panel 41 more quickly than decreasing of the output of the drive unit 73 cooling the cooler 72.

Therefore, according to the above described configuration, when the temperature of the liquid crystal panel 41 is lower and when the ambient temperature of the liquid crystal panel 41 is lower, the liquid crystal panel 41 may be quickly warmed.

In the warming processing SB, the control unit 75 increases the warming output to the liquid crystal panel 41 by the thermoelectric conversion device 71 in a stepwise manner. Specifically, when the temperature of the liquid crystal panel 41 is not equal to or higher than the above described lower limit value, the control unit 75 increases the output of the thermoelectric conversion device 71 in a stepwise manner until the output of the thermoelectric conversion device 71 reaches 100%.

According to the configuration, the liquid crystal panel 41 may be kept within the appropriate temperature range while the power consumption with the warming of the liquid crystal panel 41 is suppressed.

In the warming processing SB, the control unit 75 decreases the output of the drive unit 73 in a stepwise manner. Specifically, when the temperature of the liquid crystal panel 41 is not equal to or higher than the above described lower limit value, the control unit 75 decreases the output of the drive unit 73 in a stepwise manner until the output of the drive unit 73 becomes lower than 20%.

According to the configuration, the liquid crystal panel 41 may be kept within the appropriate temperature range while the power consumption with the warming of the liquid crystal panel 41 is suppressed.

In the cooling processing SA, the control unit 75 includes the cooling control of the liquid crystal panel 41 by the thermoelectric conversion device 71 and the output increase control of the drive unit 73.

According to the configuration, the control unit 75 controls the thermoelectric conversion device 71 and the drive unit 73, and thereby, the temperature adjustment of the liquid crystal panel 41 in the cooling processing SA may be finely performed.

In the cooling processing SA, the control unit 75 executes the cooling control of the liquid crystal panel 41 by the thermoelectric conversion device 71 in preference to the output increase control of the drive unit 73.

Here, the heat absorption of the liquid crystal panel 41 by the thermoelectric conversion device 71 may decrease the temperature of the liquid crystal panel 41 more quickly than increasing of the output of the drive unit 73 cooling the cooler 72.

Therefore, according to the above described configuration, when the temperature of the liquid crystal panel 41 is higher and when the ambient temperature of the liquid crystal panel 41 is higher, the liquid crystal panel 41 may be quickly cooled.

The drive unit 73 is the cooling fan cooling the cooler 72 by circulating the cooling gas in the cooler 72. Accordingly, when the temperature of the liquid crystal panel 41 reaches within the suitable temperature range by the cooling control of the thermoelectric conversion device 71, the output of the drive unit 73 is not increased. Therefore, generation of noise including wind noise and drive noise with the output increase of the drive unit 73 as the cooling fan may be suppressed.

In the cooling processing SA, the control unit 75 increases the output of the thermoelectric conversion device 71 in a stepwise manner. Specifically, when the temperature of the liquid crystal panel 41 is not equal to or lower than the above described upper limit value, the control unit 75 increases the output of the thermoelectric conversion device 71 until the output of the thermoelectric conversion device 71 reaches 100%.

According to the configuration, the liquid crystal panel 41 may be easily kept within the appropriate temperature range while the power consumption with the cooling of the liquid crystal panel 41 is suppressed.

In the cooling processing SA, the control unit 75 increases the output of the drive unit 73 in a stepwise manner. Specifically, when the temperature of the liquid crystal panel 41 is not equal to or lower than the above described upper limit value, the control unit 75 increases the output of the drive unit 73 in a stepwise manner until the output of the drive unit 73 reaches 100%.

According to the configuration, the liquid crystal panel 41 may be easily kept within the appropriate temperature range while the power consumption with the cooling of the liquid crystal panel 41 is suppressed.

The cooler 72 is the heat sink coupled to the second surface 712 of the thermoelectric conversion device 71. The drive unit 73 is the fan circulating the cooling wind in the cooler 72 as the heat sink.

According to the configuration, when the amount of generated heat of the liquid crystal panel 41 is lower, compared to a case where configurations circulating a liquid refrigerant are employed as the cooler 72 and the drive unit 73, the cooler 72 and the drive unit 73 may be simply formed and the cost of the projector 1 as the electronic apparatus may be reduced.

The thermoelectric conversion device 71 is the Peltier element. The control unit 75 sets the polarity of the Peltier element to be opposite in the cooling processing SA and the warming processing SB.

According to the configuration, the control unit 75 controls the polarity of the thermoelectric conversion device 71 as the Peltier element, and thereby, the warming of the liquid crystal panel 41 and the cooling of the liquid crystal panel 41 may be easily switched.

The control unit 75 is a controller controlling the temperature of the liquid crystal panel 41 of the light modulation unit 353. The light modulation unit 353 includes the liquid crystal panel 41, the thermal diffuser 5 in contact with the liquid crystal panel 41, in which the received heat is diffused, and the thermoelectric conversion device 71 in contact with the thermal diffuser 5.

The control unit 75 is configured to execute the cooling processing SA and the warming processing SB.

The cooling processing SA is the processing of absorbing the heat of the liquid crystal panel 41 transferred from the liquid crystal panel 41 to the thermal diffuser 5 by the thermoelectric conversion device 71 and diffused in the thermal diffuser 5.

The warming processing SB is the processing of supplying heat to the thermal diffuser 5 by the thermoelectric conversion device 71 and warming the liquid crystal panel 41 by the heat diffused in the thermal diffuser 5 and transferred to the liquid crystal panel 41.

According to the configuration, the same effects as those of the above described temperature adjustment apparatus 7 may be exerted.

### Modification of First Embodiment

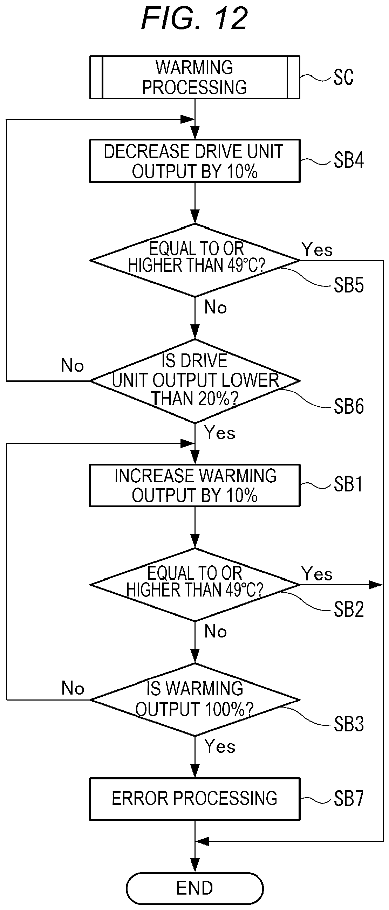

FIG. 12 is a flowchart showing warming processing SC as a modification of the warming processing SB.

In the above described warming processing SB, the control unit 75 executes the warming control of the liquid crystal panel 41 by the thermoelectric conversion device 71 in preference to the output decrease control of the drive unit 73. However, the control unit 75 may execute e.g., the warming processing SC shown in FIG. 12 in place of the warming processing SB.

The warming processing SC includes the warming control of the liquid crystal panel 41 by the thermoelectric conversion device 71 and the output decrease control of the drive unit 73 like the warming processing SB. On the other hand, in the warming processing SC, the control unit 75 executes the output decrease control of the drive unit 73 in preference to the warming control of the liquid crystal panel 41 by the thermoelectric conversion device 71.

Specifically, in the warming processing SC, as shown in FIG. 12, the control unit 75 executes steps SB4 to SB6 included in the warming processing SB shown in FIG. 11 in preference to steps SB1 to SB3.

In the warming processing SC, in the determination processing at step SB5, when a determination that the temperature of the liquid crystal panel 41 is equal to or higher than 49 °C is made (step SB5: Yes), the control unit 75 ends the warming processing SC.

In the warming processing SC, in the determination processing at step SB6, when a determination that the output of the drive unit 73 is lower than 20% is made (step SB6: Yes), the control unit 75 executes steps SB1 to SB3 included in the warming processing SB shown in FIG. 11.

In the warming processing SC, in the determination processing at step SB2, when a determination that the temperature of the liquid crystal panel 41 is equal to or higher than 49 °C is made (step SB2: Yes), the control unit 75 ends the warming processing SC.

In the warming processing SC, in the determination processing at step SB3, when a determination that the warming output of the thermoelectric conversion device 71 reaches 100% is made (step SB3: Yes), the control unit 75 executes error processing at step SB7 and ends the warming processing SC.

The control unit 75 executes the above described warming processing SC in place of the warming processing SB, and thereby, the projector 1 may exert the following effects.

That is, in the warming processing SC, the control unit 75 executes the output decrease control of the drive unit 73 in preference to the warming control of the liquid crystal panel 41 by the thermoelectric conversion device 71.

Here, the warming of the liquid crystal panel 41 by the thermoelectric conversion device 71 consumes more power than the decreasing of the output of the drive unit 73 cooling the cooler 72.

Therefore, according to the configuration, the liquid crystal panel 41 may be warmed while the power consumption with warming of the liquid crystal panel 41 is suppressed.

### Second Embodiment

Next, a second embodiment of the present disclosure will be explained.

A projector according to the embodiment has a similar configuration as the projector 1 according to the first embodiment, and different in the configuration of the temperature adjustment apparatus and the configuration of the cooler. Note that, in the following description, the same or substantially the same parts as the above described parts have the same signs and the explanation thereof will be omitted.

### Configuration of Projector

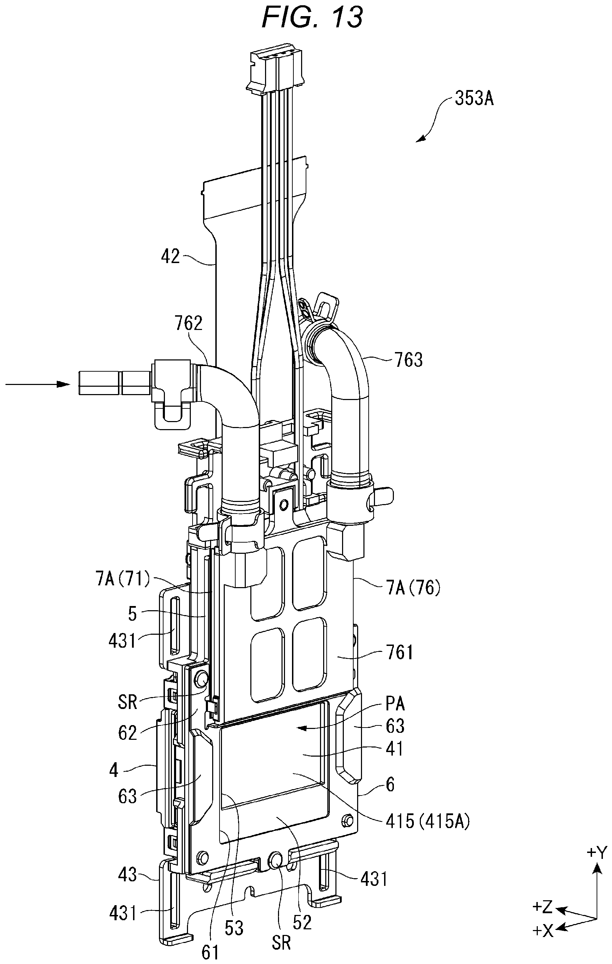

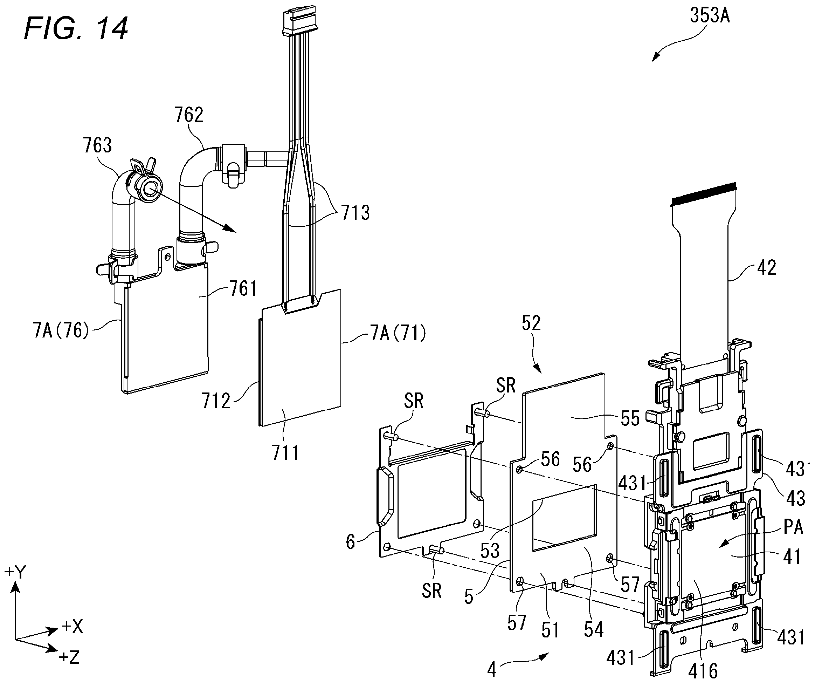

FIG. 13 is a perspective view showing a light modulation unit 353A of the projector according to the embodiment as seen from the light incident side. FIG. 14 is an exploded perspective view showing the light modulation unit 353A as seen from the light exiting side.

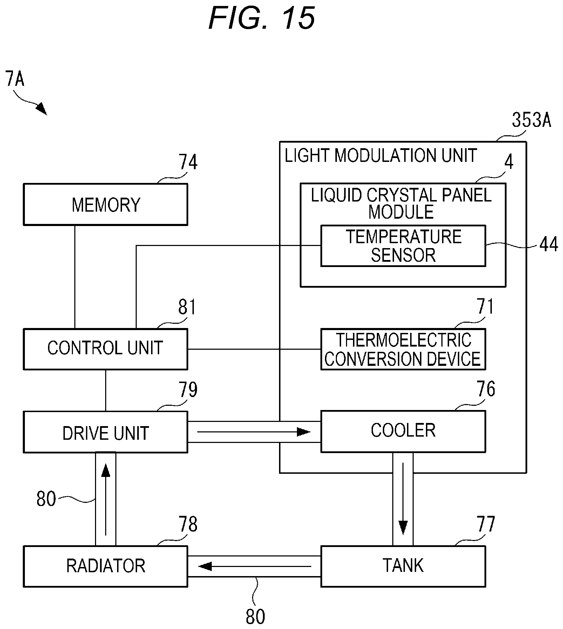

FIG. 15 is a block diagram showing a configuration of a temperature adjustment apparatus 7A of the projector according to the embodiment.

The projector according to the embodiment has the same configurations and functions as the projector 1 according to the first embodiment except that the light modulation unit 353A shown in FIGS. 13 and 14 is provided in place of the light modulation unit 353 and the temperature adjustment apparatus 7A shown in FIG. 15 is provided in place of the temperature adjustment apparatus 7.

### Configuration of Light Modulation Unit

As shown in FIGS. 13 and 14, the light modulation unit 353A has the same configuration as the light modulation unit 353 according to the first embodiment except that a cooler 76 is attached in place of the cooler 72. That is, the light modulation unit 353A includes the liquid crystal panel module 4 and the holding member 6, the thermoelectric conversion device 71 contacts the extending portion 55 of the thermal diffuser 5 of the liquid crystal panel module 4 and the cooler 76 contacts the second surface 712 of the thermoelectric conversion device 71.

The cooler 76 dissipates heat transferred from the thermoelectric conversion device 71 like the cooler 72 according to the first embodiment. The cooler 76 includes a cooler main body 761, an inflow tube 762, and an outflow tube 763.

Though not specifically illustrated, the cooler main body 761 has a plurality of channels in which the liquid refrigerant can circulate inside and the liquid refrigerant supplied from the inflow tube 762 circulates inside. That is, the cooler 760 is a cold plate in which the liquid refrigerant circulates.

The cooler main body 761 is formed using a material of a metal having higher thermal conductivity or the like and heat-transferably fixed to the second surface 712. The heat transferred from the second surface 712 to the cooler main body 761 is transferred to the liquid refrigerant circulating within the cooler main body 761. Thereby, the cooler main body 761, i.e., the liquid crystal panel 41 are cooled.

The inflow tube 762 is a tubular member for the liquid refrigerant to flow into the cooler main body 761.

The outflow tube 763 is a tubular member for the liquid refrigerant circulated inside the cooler main body 761 to flow out.

### Configuration of Temperature Adjustment Apparatus

The temperature adjustment apparatus 7A adjusts the temperature of the liquid crystal panel 41 of each light modulation unit 353A like the temperature adjustment apparatus 7 according to the first embodiment. As shown in FIG. 15, the temperature adjustment apparatus 7A includes the thermoelectric conversion device 71, the memory 74, and the cooler 76, and further includes a tank 77, a radiator 78, a drive unit 79, a tubular member 80, and a control unit 81. Of these elements. the tubular member 80 is formed so that the liquid refrigerant can circulate inside.

The tank 77 accumulates the liquid refrigerant.

The radiator 78 is coupled to the tank 77 via the tubular member 80. The radiator 78 cools the liquid refrigerant flowing in from the tank 77.

The drive unit 79 is coupled to the radiator 78 via the tubular member 80. The drive unit 79 is a pump and pressure-feeds the liquid refrigerant cooled in the radiator 78 to the inflow tube 762 of the cooler 76. The liquid refrigerant pressure-fed by the drive unit 79 circulates in the cooler 76 and flows into the tank 77. The liquid refrigerant flowing into the tank 77 flows into the drive unit 79 again via the radiator 78.

### Configuration of Control Unit

The control unit 81 controls the thermoelectric conversion device 71 and the drive unit 79 and adjusts the temperature of the liquid crystal panel 41 like the control unit 75 according to the first embodiment. That is, the control unit 81 controls the operation of the thermoelectric conversion device 71 and the drive unit 79 based on the temperature of the liquid crystal panel 41 detected by the temperature sensor 44 of the light modulation unit 353A. Specifically, the control unit 81 executes temperature adjustment processing shown in FIG. 9 on the light modulation unit 353A with reference to the temperature adjustment program stored in the memory 74.

As shown in FIG. 9, when a determination that the temperature of the liquid crystal panel 41 detected by the temperature sensor 44 is higher than 60 °C is made, the control unit 81 executes cooling processing SA.

In the cooling processing SA, as shown in FIG. 10, the control unit 81 executes steps SA1 to SA3 and increases heat absorption output to the liquid crystal panel 41 by the thermoelectric conversion device 71 in a stepwise manner. Further, the control unit 81 executes steps SA4 to SA6 and increases output of the drive unit 79 in a stepwise manner.

When the temperature of the liquid crystal panel 41 reaches 60 °C or less, the control unit 81 ends the cooling processing SA.

Note that, in the determination processing at step SA6, when a determination that the output of the drive unit 79 reaches 100% is made (step SA6: Yes), the control unit 81 sets error information at step SA7 and, after ending the cooling processing SA, executes error processing at step S3.

Further, as shown in FIG. 9, when a determination that the temperature of the liquid crystal panel 41 detected by the temperature sensor 44 is lower than 49 °C is made, the control unit 81 executes warming processing SB or warming processing SC.

In the warming processing SB, as shown in FIG. 11, the control unit 81 executes steps SB1 to SB3 and increases warming output to the liquid crystal panel 41 by the thermoelectric conversion device 71 in a stepwise manner. Further, the control unit 81 executes steps SB4 to SB6 and decreases output of the drive unit 79 in a stepwise manner.

In the warming processing SC, as shown in FIG. 12, the control unit 81 executes steps SB4 to SB6 and decreases output of the drive unit 79 in a stepwise manner. Further, the control unit 81 executes steps SB1 to SB3 and increases warming output to the liquid crystal panel 41 by the thermoelectric conversion device 71 in a stepwise manner.

In either case where the warming processing SB or the warming processing SC is executed, when the temperature of the liquid crystal panel 41 reaches49 °C or more, the control unit 81 ends the processing.

Note that, when the temperature of the liquid crystal panel 41 does not reach 49 °C or more, but the warming output of the thermoelectric conversion device 71 reaches 100% and the output of the drive unit 79 is less than 20%, the error processing at step SB7 is executed.

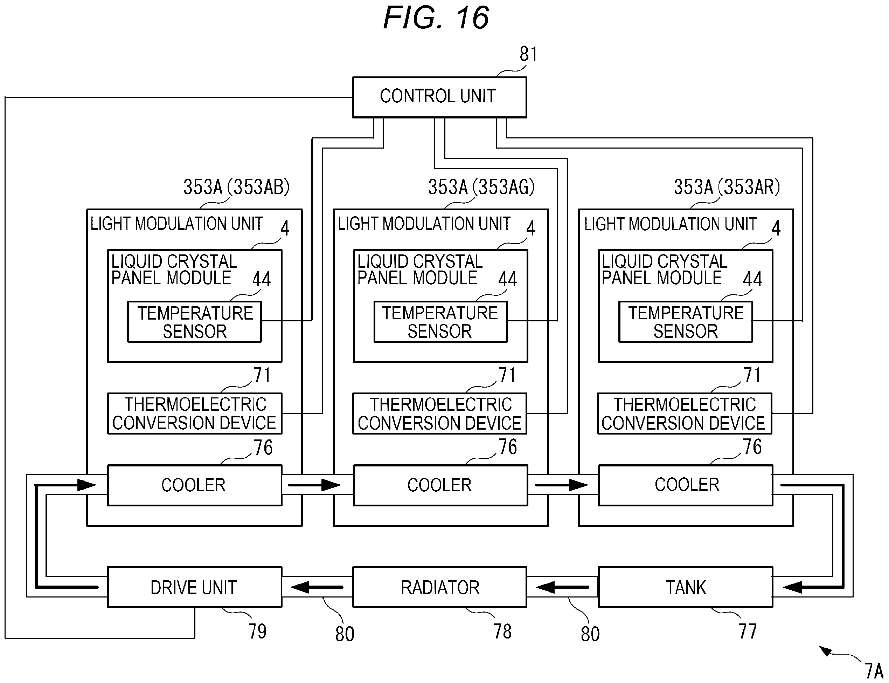

The projector according to the embodiment includes the three light modulation units 353A like the projector 1 according to the first embodiment. As shown in FIG. 16, the three light modulation units 353A include a light modulation unit 353AR for red light, a light modulation unit 353AG for green light, and a light modulation unit 353AB for blue light.

In the above described configuration example of the temperature adjustment apparatus 7, the tank 77, the radiator 78, the drive unit 79, the tubular member 80, and the control unit 81 are placed for the liquid crystal panel 41 of the single light modulation unit 353A. That is, in the above described configuration example of the temperature adjustment apparatus 7, one drive unit 79 is provided for one cooler 76.

However, the configuration is not limited to that. A plurality of coolers 76 may be coupled to a circulation channel and the liquid refrigerant may be circulated by the single drive unit 79 for the respective coolers 76.

FIG. 16 is a schematic diagram showing another example of the circulation channel of the liquid refrigerant.

In the example of FIG. 16, the inflow tube 762 of the cooler 76 provided in the light modulation unit 353AB is coupled to the drive unit 79, and the outflow tube 763 of the cooler 76 provided in the light modulation unit 353AB is coupled to the inflow tube 762 of the cooler 76 provided in the light modulation unit 353AG. The outflow tube 763 of the cooler 76 provided in the light modulation unit 353AG is coupled to the inflow tube 762 of the cooler 76 provided in the light modulation unit 353AR, and the outflow tube 763 of the cooler 76 provided in the light modulation unit 353AR is coupled to the tank 77.

In the example shown in FIG. 16, when the control unit 81 drives the drive unit 79, the liquid refrigerant circulates from the drive unit 79 in the order of the light modulation unit 353AB, the light modulation unit 353AG, and the light modulation unit 353AR. The liquid refrigerant circulated in the light modulation unit 353AR circulates the tank 77 and the radiator 78, and then, is delivered to the light modulation unit 353AB by the drive unit 79 again.

Here, the light modulation unit 353AB entered by the blue light having a wavelength near the wavelength of ultraviolet light is most likely to be deteriorated by high-energy light. Generally, in white light preferably used for image formation, the amount of green light is larger than the amounts of other color lights, and the light modulation unit 353AG is likely to be deteriorated due to the temperature. On this account, the liquid refrigerant at the lowest temperature is circulated in the light modulation unit 353AB, the liquid refrigerant circulated in the light modulation unit 353AB is circulated in the light modulation unit 353AG prior to the light modulation unit 353AR, and thereby, the respective light modulation units 353A may be effectively cooled and the deterioration of the respective light modulation units 353A may be suppressed.

In the example shown in FIG. 16, when the control unit 81 executes the above described temperature adjustment processing, the control unit 81 may execute the cooling processing SA and the warming processing SB, SC according to the temperature of the liquid crystal panel 41 at the lowest temperature or the temperature of the liquid crystal panel 41 at the highest temperature of the three liquid crystal panels 41.

For example, the control unit 81 may execute the temperature adjustment processing of the respective liquid crystal panels 41 and operate the respective thermoelectric conversion devices 71 according to the temperatures of the respective liquid crystal panels 41. That is, the respective thermoelectric conversion devices 71 may be individually controlled. Specifically, when the temperature of the liquid crystal panel 41 is higher than 60 °C, the control unit 81 may execute the cooling processing including steps SA1 to SA3 using the thermoelectric conversion device 71 corresponding to the liquid crystal panel 41, and, when the temperature of the liquid crystal panel 41 is lower than 49 °C, the control unit 81 may execute the warming processing including steps SB1 to SB3 using the thermoelectric conversion device 71 corresponding to the liquid crystal panel 41.

In a case where the cooling processing is executed, even when the heat absorption output of the thermoelectric conversion device 71 provided to correspond to the liquid crystal panel 41 at the highest temperature reaches 100%, if the temperature of the liquid crystal panel 41 is higher than 60 °C, the control unit 81 may increase the output of the drive unit 79 in a stepwise manner.

In a case where the warming processing is executed, even when the warming output of the thermoelectric conversion device 71 provided to correspond to the liquid crystal panel 41 at the lowest temperature reaches 100%, if the temperature of the liquid crystal panel 41 is lower than 49 °C, the control unit 81 may decrease the output of the drive unit 79 in a stepwise manner.

### Effects of Second Embodiment

The projector according to the above described embodiment exerts the same effects as the projector 1 according to the first embodiment, and further exerts the following effects.

The cooler 76 transfers the heat transferred from the second surface 712 of the thermoelectric conversion device 71 to the liquid refrigerant circulating inside. The drive unit 79 is the pump circulating the liquid refrigerant in the cooler 76.

According to the configuration, the heat transferred to the cooler 76 by the thermoelectric conversion device 71 may be promptly transferred to the liquid refrigerant. Therefore, even when the amount of generated heat of the liquid crystal panel 41 is higher, the temperature of the liquid crystal panel 41 may be easily decreased.

### Modifications of Embodiments

The present disclosure is not limited to the above described respective embodiments. The present disclosure includes modifications, improvements, etc. within the range in which the purpose of the present disclosure may be achieved.

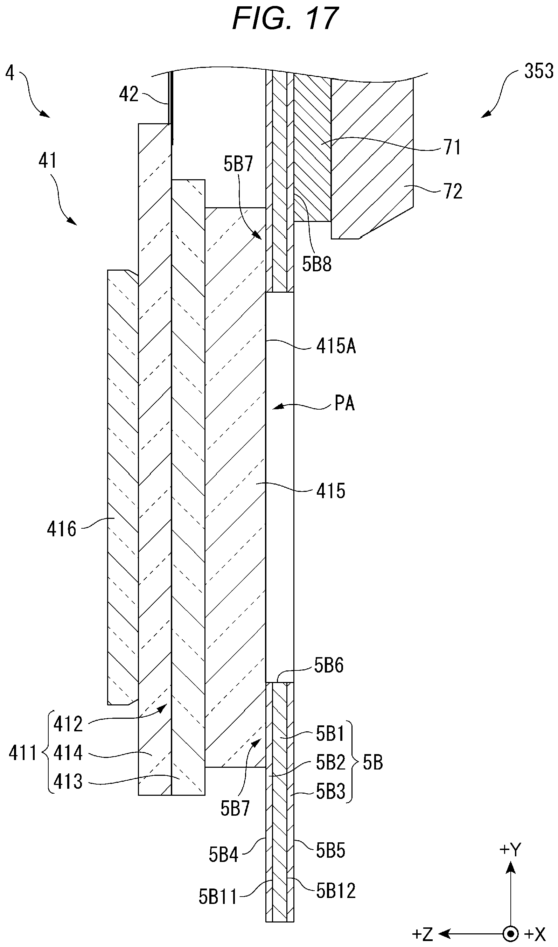

FIG. 17 is a sectional view enlarging and showing a part of the light modulation unit 353 including a thermal diffuser 5B as a modification of the thermal diffuser 5 in place of the thermal diffuser 5. Note that, in FIG. 17, the illustration of the holding frame 43 and the holding member 6 is omitted.

In the above described respective embodiments, the thermal diffuser 5 includes the vapor chamber VC having the sealed housing VC1 housing the working fluid. However, the thermal diffuser is not limited to that, but may include a different configuration from the vapor chamber VC. For example, in place of the thermal diffuser 5, the thermal diffuser 5B shown in FIG. 17 may be employed.

As shown in FIG. 17, the thermal diffuser 5B includes a supporting member 5B1, a first sheet 5B2, and a second sheet 5B3.

The supporting member 5B1 is a flat plate-like member formed using a metal such as aluminum and supports the first sheet 5B2 and the second sheet 5B3. The supporting member 5B1 has a first surface 5B11 as a surface at the liquid crystal panel 41 side and a second surface 5B12 at the opposite side to the first surface 5B11.

The first sheet 5B2 is provided on the first surface 5B11 to cover the first surface 5B11 in the +Z direction and the second sheet 5B3 is provided on the second surface 5B12 to cover the second surface 5B12 in the -Z direction. The first sheet 5B2 and the second sheet 5B3 are formed using graphite sheets or graphene sheets. That is, the thermal diffuser 5B is a thermal conductor including at least either of the graphite sheets or the graphene sheets.

The thermal diffuser 5B includes a first surface 5B4, a second surface 5B5, an opening portion 5B6, a contact portion 5B7, and an extending portion 5B8.

The first surface 5B4 is a surface facing the liquid crystal panel 41 in the thermal diffuser 5B. The first surface 5B4 is formed by the first sheet 5B2.

The second surface 5B5 is a surface at the opposite side to the first surface 5B4 in the thermal diffuser 5B. The second surface 5B5 is formed by the second sheet 5B3.

The opening portion 5B6 is a through hole penetrating the thermal diffuser 5B along the +Z direction and passes the light entering the liquid crystal panel 41 in the +Z direction. The opening portion 5B6 is formed substantially in a rectangular shape corresponding to the pixel area PA as seen from the light incident side.

The contact portion 5B7 is provided on the peripheral edge of the opening portion 5B6 in the first surface 5B4. The contact portion 5B7 contacts the light incident surface 415A as the heat transfer surface and receives the heat of the liquid crystal panel 41 from the light incident surface 415A. That is, the contact portion 5B7 is formed by the first sheet 5B2.

The extending portion 5B8 is a portion extending in a direction crossing the incident direction of the light from the contact portion 5B7 to the liquid crystal panel 41 in the thermal diffuser 5B. Specifically, the extending portion 5B8 is a portion extending from the contact portion 5B7 in the +Y direction crossing the +Z direction. The thermoelectric conversion device 71 is coupled to a portion corresponding to the extending portion 5B8 on the second surface 5B5.

In the above described thermal diffuser 5B, the heat of the liquid crystal panel 41 transferred to the contact portion 5B7 in contact with the light incident surface 415A is diffused in the first sheet 5B2 forming the contact portion 5B7 and transferred to the supporting member 5B1 and diffused in the supporting member 5B1. Further, the heat transferred to the supporting member 5B1 is transferred to the second sheet 5B3 and diffused in the second sheet 5B3. The heat diffused by the thermal diffuser 5B is absorbed by the thermoelectric conversion device 71 coupled to the extending portion 5B8.

The light modulation unit 353A according to the second embodiment can employ the thermal diffuser 5B in place of the thermal diffuser 5. The light modulation units 353, 353A including the thermal diffusers 5B in place of the thermal diffusers 5 may exert the same effects as the light modulation units 353, 353A including the thermal diffusers 5 and further have the following effects.

The thermal diffuser 5B is the thermal conductor including at least either of the graphite sheets or the graphene sheets.

Here, the graphite sheets and the graphene sheets diffuse the transferred heat within the sheets. Accordingly, the thermal conductor including the sheets is employed as the thermal diffuser 5B, and thereby, the heat transferred from the light incident surface 415A as the heat transfer surface may be easily transferred to the extending portion 5B8 and the heat of the liquid crystal panel 41 transferred to the thermal diffuser 5B may be easily absorbed by the thermoelectric conversion device 71.

Further, the heat transferred from the first surface 711 of the thermoelectric conversion device 71 to the extending portion 5B8 may be easily transferred from the extending portion 5B8 to the contact portion 5B7 and easily transferred to the liquid crystal panel 41.

Therefore, the heat of the liquid crystal panel 41 may be dissipated in the cooler 72, 76 and heat may be easily transferred from the thermoelectric conversion device 71 to the liquid crystal panel 41, and thereby, the temperature of the liquid crystal panel 41 may be easily adjusted.

Note that the thermal diffuser 5B includes the supporting member 5B1, the first sheet 5B2, and the second sheet 5B3. However, the configuration is not limited to that. The thermal diffuser 5B may include only one of the first sheet 5B2 and the second sheet 5B3. Further, if the liquid crystal panel 41 and the thermoelectric conversion device 71 can be coupled, the heat diffuser may have only one sheet and the supporting member 5B1 may be omitted.

In the above described respective embodiments, the control unit 75, 81 executes one processing of the cooling processing SA and the warming processing SB, SC based on the comparison result between the detection result of the temperature sensor 44 detecting the temperature of the liquid crystal panel 41 and the thresholds stored in the memory 74. However, the configuration is not limited to that. The control unit 75, 81 may determine the processing to execute based on the temperature inside of the exterior housing 2 or the temperature outside of the exterior housing 2. Alternatively, the control unit 75, 81 may determine the processing of the cooling processing SA and the warming processing SB, SC to execute based on an elapsed time from the start of the lighting of the light source 31. That is, the index for determination of the processing to be executed of the cooling processing SA and the warming processing SB, SC by the control unit 75, 81 is not limited to the temperature of the liquid crystal panel 41. Further, the liquid crystal panel module 4 does not necessarily include the temperature sensor 44.

In the above described first embodiment, the cooling processing SA includes the output increase control of the drive unit 73 by the control unit 75 in addition to the cooling control of the thermoelectric conversion device 71 by the control unit 75. However, the configuration is not limited to that. The cooling processing SA may include the cooling control of the thermoelectric conversion device 71 by the control unit 75, but not include the output increase control of the drive unit 73 by the control unit 75.

In the above described second embodiment, the cooling processing SA includes the output increase control of the drive unit 79 by the control unit 81 in addition to the cooling control of the thermoelectric conversion device 71 by the control unit 81. However, the configuration is not limited to that. The cooling processing SA may include the cooling control of the thermoelectric conversion device 71 by the control unit 81, but not include the output increase control of the drive unit 79 by the control unit 81.

In the cooling processing SA according to the above described first embodiment, the control unit 75 increases the output of the thermoelectric conversion device 71 in a stepwise manner and increases the output of the drive unit 73 in a stepwise manner. In the cooling processing SA according to the above described second embodiment, the control unit 81 increases the output of the thermoelectric conversion device 71 in a stepwise manner and increases the output of the drive unit 79 in a stepwise manner. However, the configuration is not limited to that. The output of the thermoelectric conversion device 71 is not necessarily increased in a stepwise manner and the output of the drive unit 73, 79 is not necessarily increased in a stepwise manner.

In the cooling processing SA according to the above described respective embodiments, the cooling control of the liquid crystal panel 41 by the thermoelectric conversion device 71 is performed in preference to the output increase control of the drive unit 73, 79. However, the configuration is not limited to that. In the cooling processing SA, the output increase control of the drive unit 73, 79 may be performed in preference to the cooling control of the liquid crystal panel 41 by the thermoelectric conversion device 71.

In the above described first embodiment, the warming processing SB, SC includes the output decrease control of the drive unit 73 by the control unit 75 in addition to the warming control of the thermoelectric conversion device 71 by the control unit 75. However, the configuration is not limited to that. The warming processing SB, SC may include the warming control of the thermoelectric conversion device 71 by the control unit 75, but not include the output decrease control of the drive unit 73 by the control unit 75.

In the above described second embodiment, the warming processing SB, SC includes the output decrease control of the drive unit 79 by the control unit 81 in addition to the warming control of the thermoelectric conversion device 71 by the control unit 81. However, the configuration is not limited to that. The warming processing SB, SC may include the warming control of the thermoelectric conversion device 71 by the control unit 81, but not include the output decrease control of the drive unit 79 by the control unit 81.

In the warming processing SB, SC according to the above described first embodiment, the control unit 75 increases the output of the thermoelectric conversion device 71 in a stepwise manner and increases the output of the drive unit 73 in a stepwise manner. In the warming processing SB, SC according to the above described second embodiment, the control unit 81 increases the output of the thermoelectric conversion device 71 in a stepwise manner and increases the output of the drive unit 79 in a stepwise manner. However, the configuration is not limited to that. The output of the thermoelectric conversion device 71 is not necessarily increased in a stepwise manner and the output of the drive unit 73, 79 is not necessarily increased in a stepwise manner.

In the above described first embodiment, the cooler 72 is the heat sink. In the above described second embodiment, the cooler 76 is formed so that the liquid refrigerant can be circulated. However, the cooler is not limited to the above described configurations.

The temperature adjustment apparatus 7 does not necessarily include the cooler 72 and the drive unit 73, and the temperature adjustment apparatus 7A does not necessarily include the cooler 76 and the drive unit 79.

In the above described respective embodiments, the thermoelectric conversion device 71 is the Peltier element. The control unit 75, 81 sets the polarity of the thermoelectric conversion devices 71 to be opposite when executing the cooling processing SA and absorbing heat from the liquid crystal panel 41 and when executing the warming processing SB, SC and warming the liquid crystal panel 41. However, the configuration is not limited to that. The thermoelectric conversion device 71 may include, not limited to the Peltier element, but another configuration as long as the device may perform heat absorption and warming of the liquid crystal panel 41.

In the above described respective embodiments, the projector includes the three light modulation units 353, 353A including the liquid crystal panel modules 4. The three light modulation units 353 include the light modulation unit 353R for red light, the light modulation unit 353G for green light, and the light modulation unit 353B for blue light. The three light modulation units 353A include the light modulation unit 353AR for red light, the light modulation unit 353AG for green light, and the light modulation unit 353AB for blue light. However, the configuration is not limited to that. The projector according to the present disclosure may include two or less or four or more light modulation units 353, 353A. For example, the projector 1 according to the present disclosure may include only one liquid crystal panel module 4.

In the above described respective embodiments, the liquid crystal panel module 4 modulates the entering light by the liquid crystal panel 41 and outputs the modulated light along the incident direction of the light to the liquid crystal panel 41. That is, the liquid crystal panel module 4 is a transmissive liquid crystal panel module. However, the configuration is not limited to that. The liquid crystal panel module according to the present disclosure may be a reflective liquid crystal panel module modulating the entering light by the liquid crystal panel and outputs the modulated light in the opposite direction to the incident direction of the light to the liquid crystal panel.

In the above described respective embodiments, the light incident surface 415A in the light incident-side dustproof substrate 415 of the liquid crystal panel 41 is the heat transfer surface being in contact with the contact portion 54, 5B7 of the thermal diffuser 5, 5B and transferring the heat of the liquid crystal panel 41 to the thermal diffuser 5, 5B. However, the configuration is not limited to that. Another portion than the light incident surface 415A may be the heat transfer surface in the liquid crystal panel 41. For example, a side surface crossing the light incident surface in at least one substrate of the counter substrate 413, the pixel substrate 414, the light incident-side dustproof substrate 415, and the light exiting-side dustproof substrate 416 may be the heat transfer surface.

Further, the contact portion 54, 5B7 of the thermal diffuser 5, 5B does not necessarily directly contact the liquid crystal panel 41. For example, the contact portion 54, 5B7 may contact a heat transfer member heat-transferably coupled to the liquid crystal panel 41. The same applies to the thermoelectric conversion device 71 in contact with the extending portion 55, 5B8 and the cooler 72, 76 in contact with the second surface 712 of the thermoelectric conversion device 71.

Furthermore, depending on the placement of the thermal diffuser 5, 5B with respect to the liquid crystal panels 41, the thermal diffuser 5, 5B does not necessarily have the opening portion 53, 5B6. The thermal diffuser 5, 5B, the thermoelectric conversion device 71, and the cooler 72, 76 may be placed at the light exiting side with respect to the liquid crystal panel 41.

In the above described respective embodiments, the projector is exemplified as an electronic apparatus including the temperature adjustment apparatus 7, 7A adjusting the temperature of the liquid crystal panel 41 of the liquid crystal panel module 4 and the control unit 75, 81 as the controller. However, the configuration is not limited to that. The electronic apparatus including the temperature adjustment apparatus 7, 7A and the control unit 75, 81 of the present disclosure is not limited to the projector, but may be an electronic apparatus including another configuration. The electronic apparatus includes e.g., a display apparatus. Summary of Present Disclosure

As below, the summary of the present disclosure will be appended.

### Appendix 1

A temperature adjustment apparatus adjusting a temperature of a liquid crystal panel module, includes a thermoelectric conversion device in contact with the liquid crystal panel module, and a control unit controlling the thermoelectric conversion device, wherein the liquid crystal panel module includes a liquid crystal panel, and a thermal diffuser having a contact portion in contact with the liquid crystal panel and an extending portion extending from the contact portion and diffusing received heat, the thermoelectric conversion device has a first surface in contact with the extending portion, and a second surface at an opposite side to the first surface, and the control unit is configured to execute warming processing of supplying heat to the thermal diffuser using the thermoelectric conversion device and warming the liquid crystal panel by the heat diffused in the thermal diffuser and transferred to the liquid crystal panel via the contact portion, and cooling processing of absorbing the heat of the liquid crystal panel transferred to the thermal diffuser by the thermoelectric conversion device via the contact portion and diffused in the thermal diffuser.

According to the configuration, the temperature of the liquid crystal panel may be increased via the thermal diffuser by the thermoelectric conversion device by the control unit executing the warming processing. Thereby, responsiveness reduction of liquid crystal of the liquid crystal panel and image degradation may be suppressed.

Further, the heat transferred from the liquid crystal panel to the thermal diffuser may be actively absorbed by the thermoelectric conversion device by the control unit executing the cooling processing. Thereby, the higher temperature of the liquid crystal panel may be suppressed and the shorter life of the liquid crystal panel may be suppressed.

Therefore, the temperature of the liquid crystal panel may be adjusted by the temperature adjustment apparatus.

### Appendix 2

The temperature adjustment apparatus according to Appendix 1 further includes a memory storing a threshold, wherein the liquid crystal panel module includes a temperature sensor detecting the temperature, and the control unit executes one processing of the warming processing and the cooling processing based on a comparison result between a detection value by the temperature sensor and the threshold.

According to the configuration, the control unit may appropriately determine which to execute the warming processing and the cooling processing by the comparison between the detection value by the temperature sensor and the threshold stored in the memory. Therefore, the temperature adjustment of the liquid crystal panel may be appropriately performed. Appendix 3

The temperature adjustment apparatus according to Appendix 2 further includes a cooler in contact with the second surface, and a drive unit cooling the cooler.

According to the configuration, compared to a case without the cooler and the drive unit, cooling efficiency of the liquid crystal panel may be increased.

### Appendix 4

In the temperature adjustment apparatus according to Appendix 3, the warming processing includes warming control of the liquid crystal panel by the thermoelectric conversion device, and output decrease control of the drive unit.

According to the configuration, the control unit controls the thermoelectric conversion device and the drive unit, and thereby, the temperature adjustment of the liquid crystal panel in the warming processing may be finely performed.

### Appendix 5

In the temperature adjustment apparatus according to Appendix 4, the control unit executes the warming control of the liquid crystal panel by the thermoelectric conversion device in preference to the output decrease control of the drive unit in the warming processing.

Here, the warming of the liquid crystal panel by the thermoelectric conversion device may increase the temperature of the liquid crystal panel more quickly than decreasing of the output of the drive unit cooling the cooler.

Therefore, according to the configuration, when the temperature of the liquid crystal panel is lower and when the ambient temperature of the liquid crystal panel is lower, the liquid crystal panel may be quickly warmed.

### Appendix 6

In the temperature adjustment apparatus according to Appendix 4, the control unit executes the output decrease control of the drive unit in preference to the warming control of the liquid crystal panel by the thermoelectric conversion device in the warming processing.

Here, the warming of the liquid crystal panel by the thermoelectric conversion device tends to consume more power than the decreasing of the output of the drive unit cooling the cooler.

Therefore, according to the configuration, the liquid crystal panel may be warmed while the power consumption with warming of the liquid crystal panel is suppressed.

### Appendix 7

In the temperature adjustment apparatus according to any one of Appendix 4 to Appendix 6, the control unit increases warming output to the liquid crystal panel by the thermoelectric conversion device in a stepwise manner in the warming processing.

According to the configuration, the liquid crystal panel may be easily kept within an appropriate temperature range while the power consumption with the warming of the liquid crystal panel is suppressed.

### Appendix 8

In the temperature adjustment apparatus according to any one of Appendix 4 to Appendix 7, the control unit decreases output of the drive unit in a stepwise manner in the warming processing.

According to the configuration, the liquid crystal panel may be easily kept within the appropriate temperature range while the power consumption with the warming of the liquid crystal panel is suppressed.

### Appendix 9

In the temperature adjustment apparatus according to any one of Appendix 3 to Appendix 8, the control unit includes cooling control of the liquid crystal panel by the thermoelectric conversion device and output increase control of the drive unit in the cooling processing.

According to the configuration, the control unit controls the thermoelectric conversion device and the drive unit, and thereby, the temperature adjustment of the liquid crystal panel in the cooling processing may be finely performed.

### Appendix 10

In the temperature adjustment apparatus according to Appendix 9, the control unit executes the cooling control of the liquid crystal panel by the thermoelectric conversion device in preference to the output increase control of the drive unit in the cooling processing.

Here, the heat absorption of the liquid crystal panel by the thermoelectric conversion device may decrease the temperature of the liquid crystal panel more quickly than increasing of the output of the drive unit cooling the cooler.

Therefore, according to the configuration, when the temperature of the liquid crystal panel is higher and when the ambient temperature of the liquid crystal panel is higher, the liquid crystal panel may be quickly cooled.

### Appendix 11

In the temperature adjustment apparatus according to Appendix 9 or Appendix 10, the control unit increases output of the thermoelectric conversion device in a stepwise manner in the cooling processing.

According to the configuration, the liquid crystal panel may be easily kept within the appropriate temperature range while the power consumption with the cooling of the liquid crystal panel is suppressed.

### Appendix 12

In the temperature adjustment apparatus according to any one of Appendix 9 to Appendix 11, the control unit increases output of the drive unit in a stepwise manner in the cooling processing.

According to the configuration, the liquid crystal panel may be easily kept within the appropriate temperature range while the power consumption with the cooling of the liquid crystal panel is suppressed.

### Appendix 13

In the temperature adjustment apparatus according to any one of Appendix 3 to Appendix 12, the cooler is a heat sink coupled to the second surface, and the drive unit is a fan circulating cooling wind in the heat sink.

According to the configuration, when the amount of generated heat of the liquid crystal panel is lower, compared to a case where configurations circulating the liquid refrigerant are employed as the cooler and the drive unit, the cooler and the drive unit may be simply formed and the cost may be reduced.

### Appendix 14

In the temperature adjustment apparatus according to any one of Appendix 3 to Appendix 12, the cooler transfers heat transferred from the second surface to a liquid refrigerant circulating inside, and the drive unit is a pump circulating the liquid refrigerant in the cooler.

According to the configuration, the heat transferred to the cooler by the thermoelectric conversion device may be promptly transferred to the liquid refrigerant. Therefore, even when the amount of generated heat of the liquid crystal panel is higher, the temperature of the liquid crystal panel may be easily decreased.

### Appendix 15

In the temperature adjustment apparatus according to any one of Appendix 1 to Appendix 14, the thermoelectric conversion device is a Peltier element, and the control unit sets polarity of the Peltier element to be opposite in the warming processing and the cooling processing.

According to the configuration, the control unit controls the polarity of the Peltier element, and thereby, the warming of the liquid crystal panel and the cooling of the liquid crystal panel may be easily switched.

### Appendix 16

A control apparatus controlling a temperature of a liquid crystal panel of a light modulation unit including the liquid crystal panel, a thermal diffuser in contact with the liquid crystal panel and diffusing received heat inside, and a thermoelectric conversion device in contact with the thermal diffuser, configured to execute warming processing of supplying heat to the thermal diffuser using the thermoelectric conversion device and warming the liquid crystal panel by the heat diffused in the thermal diffuser and transferred to the liquid crystal panel, and cooling processing of absorbing the heat of the liquid crystal panel transferred from the liquid crystal panel to the thermal diffuser by the thermoelectric conversion device and diffused in the thermal diffuser.

According to the configuration, the same effects as those of the above described temperature adjustment apparatus may be exerted.

## Claims

1. A temperature adjustment apparatus adjusting a temperature of a liquid crystal panel module, comprising:
a thermoelectric conversion device in contact with the liquid crystal panel module; and
a control unit controlling the thermoelectric conversion device, wherein
the liquid crystal panel module includes
a liquid crystal panel, and
a thermal diffuser having a contact portion in contact with the liquid crystal panel and an extending portion extending from the contact portion and diffusing received heat,
the thermoelectric conversion device has
a first surface in contact with the extending portion, and
a second surface at an opposite side to the first surface, and
the control unit is configured to execute
warming processing of supplying heat to the thermal diffuser using the thermoelectric conversion device and warming the liquid crystal panel by the heat diffused in the thermal diffuser and transferred to the liquid crystal panel via the contact portion, and
cooling processing of absorbing the heat of the liquid crystal panel transferred to the thermal diffuser by the thermoelectric conversion device via the contact portion and diffused in the thermal diffuser.

2. The temperature adjustment apparatus according to claim 1, further comprising a memory storing a threshold, wherein
the liquid crystal panel module includes a temperature sensor detecting the temperature, and
the control unit executes one processing of the warming processing and the cooling processing based on a comparison result between a detection value by the temperature sensor and the threshold.

3. The temperature adjustment apparatus according to claim 2, further comprising:
a cooler in contact with the second surface; and
a drive unit cooling the cooler.

4. The temperature adjustment apparatus according to claim 3, wherein
the warming processing includes warming control of the liquid crystal panel by the thermoelectric conversion device, and output decrease control of the drive unit.

5. The temperature adjustment apparatus according to claim 4, wherein
the control unit executes the warming control of the liquid crystal panel by the thermoelectric conversion device in preference to the output decrease control of the drive unit in the warming processing.

6. The temperature adjustment apparatus according to claim 4, wherein
the control unit executes the output decrease control of the drive unit in preference to the warming control of the liquid crystal panel by the thermoelectric conversion device in the warming processing.

7. The temperature adjustment apparatus according to any one of claims 4 to 6,
wherein
the control unit increases warming output to the liquid crystal panel by the thermoelectric conversion device in a stepwise manner in the warming processing.

8. The temperature adjustment apparatus according to any one of claims 4 to 7,
wherein
the control unit decreases output of the drive unit in a stepwise manner in the warming processing.

9. The temperature adjustment apparatus according to any one of claims 3 to 8,
wherein
the control unit includes cooling control of the liquid crystal panel by the thermoelectric conversion device and output increase control of the drive unit in the cooling processing.

10. The temperature adjustment apparatus according to claim 9, wherein
the control unit executes the cooling control of the liquid crystal panel by the thermoelectric conversion device in preference to the output increase control of the drive unit in the cooling processing.

11. The temperature adjustment apparatus according to either claim 9 or claim 10,
wherein
the control unit increases output of the thermoelectric conversion device in a stepwise manner in the cooling processing.

12. The temperature adjustment apparatus according to any one of claims 9 to claim 11, wherein
the control unit increases output of the drive unit in a stepwise manner in the cooling processing.

13. The temperature adjustment apparatus according to any one of claims 3 to 12,
wherein
the cooler is a heat sink coupled to the second surface, and
the drive unit is a fan circulating cooling wind in the heat sink.

14. The temperature adjustment apparatus according to any one of claims 3 to 12,
wherein
the cooler transfers heat transferred from the second surface to a liquid refrigerant circulating inside, and
the drive unit is a pump circulating the liquid refrigerant in the cooler.

15. The temperature adjustment apparatus according to any one of claims 1 to 14,
wherein
the thermoelectric conversion device is a Peltier element, and
the control unit sets polarity of the Peltier element to be opposite in the warming processing and the cooling processing.

16. A control apparatus controlling a temperature of a liquid crystal panel of a light modulation unit including the liquid crystal panel, a thermal diffuser in contact with the liquid crystal panel and diffusing received heat inside, and a thermoelectric conversion device in contact with the thermal diffuser, configured to execute:
warming processing of supplying heat to the thermal diffuser using the thermoelectric conversion device and warming the liquid crystal panel by the heat diffused in the thermal diffuser and transferred to the liquid crystal panel; and
cooling processing of absorbing the heat of the liquid crystal panel transferred from the liquid crystal panel to the thermal diffuser by the thermoelectric conversion device and diffused in the thermal diffuser.
